# EUROPÄISCHE PATENTANMELDUNG

(11) **EP 4 750 032 A1**
(43) Veröffentlichungstag der Anmeldung: **27.05.2026**
(21) Anmeldenummer: 25196011.8
(22) Anmeldetag: 14.08.2025
(51) Int. Cl.: H04L 67/1095, G06F 16/27, G06F 16/14, H03M 7/30, H03M 7/40

(54) **VERFAHREN ZUR OPPORTUNISTISCHEN KOMMUNIKATION ZWISCHEN NETZWERKKNOTEN**

(30) Priorität: 19.08.2024 DE 102024207872
(71) Anmelder: Fraunhofer-Gesellschaft zur Förderung der angewandten Forschung e.V., 80686 München (DE)
(72) Erfinder: ROGGE, Henning, 53343 Wachtberg, (DE); WEBER, Daniel, 53343 Wachtberg (DE); BÖRRIES, Alexander, 53343 Wachtberg, (DE)
(74) Vertreter: Pfenning, Meinig & Partner mbB

(57) **Zusammenfassung**

Die Erfindung betrifft ein Verfahren, einen Netzwerkknoten, ein Netzwerk, ein computerlesbares Medium und ein Computerprogramprodukt.

Der Datenaustausch erfolgt üblicherweise Ende-zu-Ende, beginnend bei den Endgeräten über Internet Service Provider (ISPs) und Internetknoten bis hin zu Serverendpunkten der Online-Anbieter. Dies erfordert eine durchgängige und zuverlässige Verbindung über sämtliche Netzwerksegmente hinweg. Wenn ein Teil dieser Verbindung oder die zugrunde liegenden Dienste beeinträchtigt oder unterbrochen werden, kommt es auch zu Ausfällen nachgelagerter Anwendungen wie E-Mail und Messenger aus. Besonders anfällig sind hierbei cloudbasierte Anwendungen.

## Beschreibung

Die Erfindung betrifft ein Verfahren, einen Netzwerkknoten, ein Netzwerk, ein computerlesbares Medium und ein Computerprogramprodukt.

Der Datenaustausch erfolgt üblicherweise Ende-zu-Ende, beginnend bei den Endgeräten über Internet Service Provider (ISPs) und Internetknoten bis hin zu Serverendpunkten der Online-Anbieter. Dies erfordert eine durchgängige und zuverlässige Verbindung über sämtliche Netzwerksegmente hinweg. Wenn ein Teil dieser Verbindung oder die zugrunde liegenden Dienste beeinträchtigt oder unterbrochen werden, kommt es auch zu Ausfällen nachgelagerter Anwendungen wie E-Mail und Messenger aus. Besonders anfällig sind hierbei cloudbasierte Anwendungen.

Behörden und Katastrophenschutz sind insbesondere in Krisenfällen auf eine funktionierende Kommunikation angewiesen. Die dabei genutzten Kommunikationsmedien wie 5G/LTE, Skylink oder DSL werden jedoch bisher getrennt voneinander eingesetzt und nur über ISPs und Internetknoten verbunden.

Im Falle eines Infrastrukturausfalls ist es notwendig, auf interoperable und dezentrale Dienste und Kommunikationssysteme zurückzugreifen. Das Aufsetzen und der Betrieb solcher Eigenlösungen erfordern langfristig personelle Kompetenzen und Kapazitäten. Zudem ist die Interoperabilität über verschiedene Dienststellen hinweg aufgrund unterschiedlicher Administrationsdomänen oft nicht gewährleistet.

Darüber hinaus können im Katastropheneinsatz DDIL- Umgebungen (disrupted, disconnected, intermittent and low-bandwidth) auftreten, die durch Störungen, regelmäßige Unterbrechungen und niedrige Bandbreiten gekennzeichnet sind. In solchen Fällen reichen die frei verfügbaren Mittel aus Software und Hardware oft nicht aus, um diese Herausforderungen zu bewältigen.

Bisherige Lösungsansätze adressieren nur Teilaspekte der Probleme und nicht deren Gesamtheit. Um die Verfügbarkeit zu erhöhen, werden mehrere unabhängige Kommunikationswege genutzt, wie etwa verschiedene Mobilfunkverbindungen von unterschiedlichen Anbietern, oder 5G/LTE als Fallback für DSL. Diese Maßnahmen schützen zwar vor dem Ausfall eines einzelnen Pfads, aber sobald der Ausfall oder das Schadensgebiet eine kritische Größe erreicht, brechen alle Verbindungen zusammen. Außerdem ist eine gemeinsame Nutzung oder Zusammenführung der Ressourcen derzeit nicht möglich.

TETRA (Terrestrial Trunked Radio) ist ein Standard für digitale Funkkommunikation, der vor allem von Behörden und Organisationen mit Sicherheitsaufgaben genutzt wird. Aufgrund der geringen Datenrate und eingeschränkten Bedienbarkeit ist TETRA jedoch nur begrenzt für die innerbehördliche Kommunikation geeignet. In vergangenen Einsätzen hat sich zudem gezeigt, dass die starre Konfiguration von TETRA-Systemen ein flexibles Reagieren auf eine veränderte Situation sowie eine bereichsübergreifende Kommunikation erheblich erschwert.

Ein weiterer Ansatz ist die Verwendung proprietäre Software-Pakete. Diese nutzen bestehende Kommunikationswege wie LTE und übernehmen daher deren Schwächen. Der Fokus liegt dabei auf der Anwendungseben und weniger auf der Kommunikationstechnologie selbst.

Als letztes Mittel bleibt der Rückgriff auf analoge Funkgeräte, Kuriere und die Nutzung von Meldezetteln, um die Kommunikation aufrechtzuerhalten. Diese Methoden sind jedoch weniger effizient und skalierbar als digitale Kommunikationstechnologien, was zu Verzögerungen und einem erhöhten Fehlerpotenzial führen kann.

Die US 2017/0140020 A1 beschreibt eine Datensynchronisierung umfassend den Empfang einer Aktualisierungsanforderung von einem Client-System für einen ersten Datensatz, wobei die Aktualisierungsanforderung Suchkriterien, die zur anfänglichen Bestimmung des ersten Datensatzes verwendet werden, und Hash-Zusammenfassungen von Datensätzen des ersten Datensatzes umfasst. Die Suche erzeugt einen zweiten Datensatzsatz von Datensätzen mit Hash-Zusammenfassungen.

Die US 2012/0303582 A1 betrifft Systeme und Verfahren zur lokalen differentiellen Kompression. Lokale differentielle Kompression kann es einem Computer ermöglichen, Daten effizient über ein Netzwerk mit begrenzter oder eingeschränkter Bandbreite zu übertragen. Zum Beispiel kann ein erster Computer ein Datenobjekt zwischen dem ersten Computer und einem zweiten Computer synchronisieren, indem er eine Liste von Teilen eines zu synchronisierenden Datenobjekts bestimmt und die Liste an den zweiten Computer sendet. Wenn der zweite Computer die Liste erhalten hat, kann der zweite Computer das Datenobjekt auf der Grundlage der Liste, der entsprechend der Liste abgerufenen Daten und anderer bereits im zweiten Computer vorhandener Daten aufbauen.

Die US 2019/0026352 A1 beschreibt ein System und Verfahren für die Replikation von Datenbanken. In einer Ausführungsform werden eine oder mehrere aus einer Transaktion erzeugte Datenseiten an einem ersten Knoten erhalten.

Die eine oder mehreren Datenseiten werden komprimiert. Die komprimierten Datenseiten werden in eine erste Warteschlange in einem Speicher des ersten Knotens eingefügt. Die erste Warteschlange enthält eine Vielzahl von Blöcken. Ein erster Block der komprimierten Datenseiten in der ersten Warteschlange wird an einen zweiten Knoten übertragen, wenn der erste Block der komprimierten Datenseiten für die Replikation verfügbar wird. Der erste Block der komprimierten Datenseiten wird in einem persistenten Speicher des ersten Knotens gespeichert.

Die US 2019/0370243 A1 beschreibt ein Verfahren umfassend das Identifizieren von Daten, die von einem aus einer Vielzahl von Knoten empfangen oder erzeugt werden; das Replizieren der Daten in eine Vielzahl von Speicherkomponenten; das Empfangen einer Anforderung für die Daten an einem ersten Knoten aus der Vielzahl von Knoten; das Feststellen, dass ein Cache des ersten Knotens die Daten nicht enthält; das Identifizieren eines zweiten Knotens aus der Vielzahl von Knoten, der eine Kennung hat, die anzeigt, dass die Daten in dem zweiten Knoten gespeichert sind; Identifizieren eines zweiten Knotens aus der Vielzahl von Knoten, der eine Kennung hat, die anzeigt, dass die Daten in dem zweiten Knoten gespeichert sind; Anfordern, dass der zweite Knoten aus der Vielzahl von Knoten die Anforderung bedient; Feststellen, dass der zweite Knoten aus der Vielzahl von Knoten nicht auf die Anforderung geantwortet hat; Identifizieren eines dritten Knotens aus der Vielzahl von Knoten, der die Kennung hat; Anfordern, dass der dritte Knoten aus der Vielzahl von Knoten die Anforderung bedient; Abrufen der Antwort auf die Anforderung; und Bereitstellen der Daten an den ersten Knoten.

Die DE 11 2021 008 221 T5 beschreibt ein Kommunikationssystem. Eine erste Drahtlos-Kommunikationseinrichtung empfängt von einer ersten betreffenden Einrichtung in einem Übertragungsbereich gespeicherte Daten als betreffende Daten, erwirbt aus einer ersten Musterliste eine Muster-Kennung, die den gleichen Musterdaten wie die betreffenden Daten zugeordnet ist, und überträgt die erworbene Muster-Kennung drahtlos. Eine zweite Drahtlos-Kommunikationseinrichtung empfängt drahtlos die übertragene Muster-Kennung, erwirbt Musterdaten, die der gleichen Muster-Kennung wie eine aus einer zweiten Musterliste empfangene Muster-Kennung zugeordnet sind, und überträgt die erworbenen Musterdaten an die zweite betreffende Einrichtung Es ist Aufgabe der vorliegenden Erfindung, gemäß den nachfolgenden Aspekten eine verbesserte Lösung anzubieten, welche eine oder mehrere der vorstehend genannten Nachteile oder Probleme des Stands der Technik adressiert.

Diese Aufgabe wird gelöst durch ein Verfahren nach Anspruch 1, ein Verfahren nach Anspruch 9, ein Verfahren nach Anspruch 24, ein Netzwerk nach Anspruch 27, einen Netzwerkknoten nach Anspruch 28, ein Netzwerk nach Anspruch 29, ein computerlesbares Medium nach Anspruch 30 und ein Computerprogrammprodukt nach Anspruch 31. Die abhängigen Ansprüche geben vorteilhafte Weiterbildungen des erfindungsgemäßen Verfahrens an.

Gemäß einem ersten Aspekt der Erfindung wird die Aufgabe gelöst durch ein Verfahren, vorzugsweise ein Verfahren zur Datensynchronisation, durchgeführt von einem ersten Netzwerkknoten oder ein Chipsystem für den ersten Netzwerkknoten, umfassend: Senden einer Anfrage an einen zweiten Netzwerkknoten, wobei die Anfrage einen Indikator umfasst, der einen ersten Datensatz auf dem ersten Netzwerkknoten indiziert; Empfangen einer Antwort von dem zweiten Netzwerkknoten, wobei die Antwort einen dritten Datensatz umfasst, der einem vierten Datensatz auf dem zweiten Netzwerkknoten entspricht, wobei der vierte Datensatz eine Differenz zwischen einem zweiten Datensatz auf dem zweiten Netzwerkknoten und dem ersten Datensatz umfasst, wobei der zweite Datensatz den vierten Datensatz umfasst; und Speichern des vierten Datensatzes auf dem ersten Netzwerkknoten auf Basis der Antwort.

Das Verfahren kann auch als ein Verfahren zur Datensynchronisation in einem Netzwerk verstanden werden, wobei das Netzwerk eine Mehrzahl von Netzwerkknoten umfasst, welche den ersten Netzwerkknoten und den zweiten Netzwerkknoten umfasst.

Der zweite Netzwerkknoten ist vorzugsweise ein Nachbarknoten des ersten Netzwerkknotens, mit dem der erste Netzwerkknoten direkt kommunizieren kann, vorzugsweise ohne einen Relaisknoten nutzen zu müssen.

Die Anfrage kann auch als "Pull-Request" bezeichnet werden, da sie zum Ziel hat, Daten aus einem anderen Netzwerkknoten zu "ziehen". Infolgedessen kann die Antwort als "Pull-Response" bezeichnet werden, da sie als eine Antwort auf die Anfrage, nämlich auf die "Pull-Request", verstanden werden kann.

Der dritte Datensatz entspricht dem vierten Datensatz. Das bedeutet beispielsweise, dass der dritte Datensatz aus einer Komprimierung des vierten Datensatzes erzeugt ist, aus einer Umwandlung des vierten Datensatzes entstanden ist, oder dass der dritte Datensatz und der vierte Datensatz identisch sind.

Eine Differenz zwischen dem zweiten Datensatz und dem ersten Datensatz, oder in anderen Worten ein Unterschied zwischen dem zweiten Datensatz und dem ersten Datensatz, bezieht sich vorzugsweise auf ein Datenelement, einen Dateneintrag oder eine Dateneinheit, die im zweiten Datensatz enthalten, aber im ersten Datensatz nicht enthalten ist.

Die Anfrage enthält einen Indikator, der den ersten Datensatz auf dem ersten Netzwerkknoten indiziert, sodass der zweite Netzwerkknoten auf Basis des Indikators bestimmen kann, ob der erste Datensatz den zweiten Datensatz auf dem zweiten Netzwerkknoten umfasst, oder anders gesagt, ob eine Differenz zwischen dem zweiten Datensatz und dem ersten Datensatz vorliegt.

Mit dem obigen genannten Verfahren kann ein Datensatz von einem Netzwerkknoten auf einen benachbarten Netzwerkknoten übertragen oder in anderen Worten synchronisiert werden.

Zudem wird mit dieser Lösung anstelle des gesamten zweiten Datensatzes auf dem zweiten Netzwerkknoten nur die Differenz zwischen dem zweiten Datensatz und dem ersten Datensatz übertragen werden. Auf diese Weise kann die Größe der zu übertragenden Daten erheblich reduziert werden, sodass die Effizienz der Datenübertragung gesteigert wird und die benötigte Bandbreite reduziert wird.

Mit diesem Verfahren können Daten zwischen allen benachbarten Knoten in einem Netzwerk synchronisiert werden, falls jeder Knoten in dem Netzwerk das Verfahren, vorzugsweise regelmäßig, durchführt, sodass Daten von einem Quellknoten zu einem Zielknoten schrittweise übertragen werden können.

Ein wesentlicher Vorteil dieser Lösung besteht darin, dass sie unabhängig von einer bestehenden funktionierenden Infrastruktur ist. Sie kann sowohl zur Ersetzung als auch zur Erweiterung vorhandener Infrastrukturen verwendet werden. Dies ermöglicht eine opportunistische Datenübertragung, die beispielsweise bei einem Ausfall stoppt und beim Wiederhochfahren der Infrastruktur nahtlos fortgesetzt wird, und zudem günstige Gelegenheiten nutzt, die sich im Netzwerk ergeben, um Daten schrittweise, Knoten für Knoten, zu propagieren.

Ein weiterer Vorteil dieser Lösung liegt in der Möglichkeit der nahtlosen Integration in bestehende Technologie-Stacks. Eine auf dieser Lösung basierende Software fungiert hierbei als Speicher- und Datenaustauschplattform. Diese kann von Geräten oder anderer Software als Alternative zu Ende-zu-Ende Verbindungen genutzt werden. Eine Anbindung von Anwendungen für den Datenaustausch zwischen benachbarten Netzwerkknoten kann hierbei entweder über eine REST-API oder das Dateisystem erfolgen.

Weitere diesbezügliche Schritte in einem interaktiven Verfahren, das vorzugsweise durch den zweiten Netzwerkknoten durchgeführt wird, werden unter dem folgenden zweiten Aspekt der Erfindung diskutiert.

Um unnötige Anfragen zu sparen, umfasst das Verfahren vorzugsweise ferner die folgenden Schritte, bevor die Anfrage an den zweiten Netzwerkknoten gesendet wird: Erzeugen eines ersten Hashs auf Basis des ersten Datensatzes auf dem ersten Netzwerkknoten; Broadcasting des ersten Hashs an einen oder mehrere Netzwerkknoten, welche den zweiten Netzwerkknoten umfassen; und/oder Empfangen eines zweiten Hashs von dem zweiten Netzwerkknoten, wobei der zweite Hash auf Basis des zweiten Datensatzes auf dem zweiten Netzwerkknoten erzeugt ist.

Mit dem Verfahren können Anfragen gespart werden, wenn Daten zwischen zwei benachbarten Netzwerkknoten gleich sind, oder bereits synchronisiert worden sind, sodass die Kommunikationseffizienz erhöht werden kann. Weitere diesbezügliche Schritte in einem interaktiven Verfahren, das vorzugsweise von dem zweiten Netzwerk durchgeführt wird, werden im folgenden zweiten Aspekt der Erfindung diskutiert.

In einer Ausführungsform wird der erste Hash bzw. der zweite Hash jeweils durch eine Hash-Funktion erzeugt, die den ersten Datensatz bzw. den zweiten Datensatz als Eingabe nimmt.

In einer weiter bevorzugten Ausführungsform wird der erste Hash bzw. der zweite Hash jeweils durch ein Hashkettenbasiertes Verfahren erzeugt. Dieses Verfahren unterteilt den ersten Datensatz bzw. den zweiten Datensatz vorzugsweise in Teile und verwendet rekursive Hash-Berechnungen. Somit kann der Aufwand für die Erzeugung des ersten Hashs oder des zweiten Hashs reduziert werden. Dieses Verfahren wird im Folgenden noch weiter erläutert, insbesondere in Verbindung mit der Baumstruktur der Datenspeicherung.

Vorzugsweise ist der dritte Datensatz aus einer Komprimierung des vierten Datensatzes entstanden, wobei das Speichern des vierten Datensatzes auf dem ersten Netzwerkknoten auf Basis der Antwort vorzugsweise umfasst: Dekomprimieren des dritten Datensatzes, um den vierten Datensatz zu erhalten; und Speichern des vierten Datensatzes auf dem ersten Netzwerkknoten.

In diesem Fall umfasst die Antwort vorzugsweise ferner einen Komprimierungsindikator und einen Referenzdatenindikator, wobei der Komprimierungsindikator die Komprimierung indiziert, und der Referenzdatenindikator einen Referenzdatensatz indiziert, wobei der Referenzdatensatz gemeinsame Daten zwischen dem ersten Datensatz und dem zweiten Datensatz umfasst.

Durch die Komprimierung des vierten Datensatzes wird die Datenmenge weiter reduziert, was zusätzliche Bandbreite und Zeit spart. Der Komprimierungsindikator und der Referenzdatenindikator können von dem ersten Netzwercknoten verwendet werden, um den dritten Datensatz entsprechend zu dekomprimieren, sodass der vierte Datensatz verlustfrei erhalten bleibt.

Die Komprimierung erfolgt vorzugsweise in zwei Stufen. Zunächst wird eine erste Komprimierung unter Verwendung des Referenzdatensatzes durchgeführt, gefolgt von einer zweiten Komprimierung mit dem Deflate- oder einem Lempel-Ziv-, LZ-, Algorithmus, die die Datenmenge weiter reduzieren kann, wobei der Deflate- oder LZ-Algorithmus den Referenzdatensatz verwenden kann, um ein Preset Dictionary zwischen beiden Netzwerkknoten zu erstellen und/oder zu trainieren.

Infolgedessen kann die anschließende Dekomprimierung ebenfalls in zwei Stufen erfolgen. In einer weiteren bevorzugten Ausführungsform umfasst eine Dekomprimierung des dritten Datensatzes eine erste Dekomprimierung und/oder eine zweite Dekomprimierung, wobei die erste Dekomprimierung vorzugsweise den Deflate- oder einen Lempel-Ziv-, LZ-, Algorithmus verwendet, wobei die zweite Dekomprimierung vorzugsweise unter Verwendung des Referenzdatensatzes durchgeführt wird. Ein LZ-Algorithmus kann beispielsweise ein LZ77-, ein LZ78-, ein LZMA-, ein LZSS- oder ein LZW-Algorithmus sein.

Durch die Nutzung gemeinsamer Daten als Referenzdatensatz zwischen Knoten können übereinstimmende Datenmuster in neuen Daten durch Verweise auf den Referenzdatensatz ersetzt werden. Dies bedeutet, dass, anstatt die tatsächlichen Datenmuster mehrfach zu übertragen, lediglich die Referenzen auf den bereits bekannten gemeinsamen Referenzdatensatz verwendet werden. Dadurch kann die Datenmenge erheblich reduziert werden.

Ein besonderer Vorteil dieses Ansatzes ist, dass kein separates Wörterbuch zur Komprimierung und anschließenden Dekomprimierung zwischen den Knoten übertragen werden muss. Normalerweise wird bei der Komprimierung ein Wörterbuch erstellt, dass sowohl dem sendenden als auch dem empfangenden Knoten bekannt sein muss. Durch die Verwendung eines gemeinsamen Referenzdatensatzes entfällt die Notwendigkeit, dieses Wörterbuch separat zu übertragen, was zusätzliche Bandbreite und Zeit spart.

In einer weiteren bevorzugten Ausführungsform erfolgt die Kommunikation zwischen dem ersten Netzwerkknoten und dem zweiten Netzwerkknoten opportunistisch. Wie bereits erwähnt, beschreibt der Begriff opportunistische Kommunikation eine Kommunikation oder Datenübertragung, die basierend auf Gelegenheiten oder verfügbaren Ressourcen erfolgt. Typischerweise können bei opportunistischer Kommunikation alternative Kommunikationswege oder Ressourcen genutzt werden, wenn zum Beispiel die Hauptkommunikationsverbindung möglicherweise nicht verfügbar oder suboptimal ist.

Der wesentliche Vorteil dieser Lösung besteht darin, dass sie rudimentäre Kommunikationsmöglichkeiten auch in unterbrochenen und fragmentierten Netzen aufrechterhalten kann. Dies ist besonders wichtig in Situationen, in denen keine Infrastruktur vorhanden ist oder diese aus verschiedenen Gründen nicht genutzt werden kann. Sie ermöglicht die Kommunikation in Umgebungen, in denen herkömmliche Netzwerke möglicherweise nicht verfügbar oder gestört sind. Dies ist insbesondere in Krisensituationen von großer Bedeutung.

In einer weiteren bevorzugten Ausführungsform erfolgt die Kommunikation zwischen dem ersten Netzwerkknoten und dem zweiten Netzwerkknoten durch eine IP-basierte Netzwerktechnologie über beliebige Mobilfunk- Satteliten- oder Weitverkehrsnetze, die vorzugsweise eine oder mehrere der folgenden Kommunikationswege verwendet: IEEE 802.11 , IEEE 802.3, ITU-T G.992/993, ITU-T G.9700/9701, ITU G.984 ITU-T Y.4480, 3G-6G mobile communication (3GPP).

Es ist anzumerken, dass die hier erwähnten Kommunikationswege nur beispielhaft sind. Andere Kommunikationswege können ebenfalls verwendet werden. Die Erfindung ist diesbezüglich nicht beschränkt.

Eine Mehrzahl der Kommunikationswege kann kombiniert werden, um unterschiedliche Daten bestmöglich zu übertragen, ohne eine einzelne Verbindung zu überlasten. Dadurch ist die Lösung in DDIL-Umgebungen mit geringem Durchsatz und großer Reichweite, wie beispielsweise in militärischen und BOS-Umfeldern, einsetzbar.

Falls mehrere der Kommunikationswege gleichzeitig verfügbar sind, können sie je nach vorbestimmter Priorität ausgewählt werden. Die Priorisierung ermöglicht eine effiziente Kommunikation und Datenübertragung, um die gewünschte Quality of Service (QoS) sicherzustellen. Beispielsweise können die Kommunikationswege die folgenden Prioritäten besitzen: WiFi>Halow>LoRa. In einer bevorzugten Ausführungsform sind der erste Datensatz und der zweite Datensatz jeweils in einer Baumstruktur gespeichert, wobei die Baumstruktur vier Ebenen umfasst: eine Wurzelebene, die den jeweilige Hash repräsentiert, der auf Basis des jeweiligen Datensatzes durch eine Hashfunktion generiert ist; eine erste Ebene, in welcher Identifikationen einer oder mehrerer Netzwerkknoten abgelegt sind, welche zumindest die Identifikation des Netzwerkknotens umfassen, auf dem der jeweilige Datensatz sich befindet; eine zweite Ebene, in der Informationen über eine oder mehrere Applikationen, die den einen oder mehreren Netzwerkknoten untergeordnet sind, abgelegt sind; eine dritte Ebene, in der eine oder mehrere Dateninstanzen abgelegt sind, die den einen oder mehreren Applikationen untergeordnet sind, wobei der jeweilige Datensatz Daten der ersten Ebene, der zweiten Ebene und der dritten Ebene der Baumstruktur umfasst, wobei die eine oder mehrere Dateninstanzen vorzugsweise schemafrei gespeichert sind.

Das heißt, der erste Datensatz ist vorzugsweise in einer Baumstruktur des ersten Netzwerkknotens gespeichert, wobei die Baumstruktur des ersten Netzwerkknotens vier Ebenen umfasst: eine Wurzelebene, die den ersten Hash repräsentiert, der auf Basis des ersten Datensatzes durch eine Hashfunktion generiert ist; eine erste Ebene, in welcher Identifikationen einer oder mehrerer Netzwerkknoten abgelegt sind, welche zumindest die Identifikation des ersten Netzwerkknotens umfasst; eine zweite Ebene, in der Informationen über eine oder mehrere Applikationen, die den einen oder mehreren Netzwerkknoten untergeordnet sind, abgelegt sind; eine dritte Ebene, in der eine oder mehrere Dateninstanzen abgelegt sind, die den einen oder mehreren Applikationen untergeordnet sind, wobei der erste Datensatz Daten der ersten Ebene, der zweiten Ebene und der dritten Ebene der Baumstruktur des ersten Netzwerkknotens umfasst.

Analogerweise ist der zweite Datensatz vorzugsweise in einer Baumstruktur des zweiten Netzwerkknotens gespeichert, wobei die Baumstruktur des zweiten Netzwerkknotens ebenfalls vier Ebenen umfasst: eine Wurzelebene, die den zweiten Hash repräsentiert, der auf Basis des zweiten Datensatzes durch eine Hashfunktion generiert ist; eine erste Ebene, in welcher Identifikationen einer oder mehrerer Netzwerkknoten abgelegt sind, welche zumindest die Identifikation des zweiten Netzwerkknotens umfasst; eine zweite Ebene, in der Informationen über eine oder mehrere Applikationen, die den einen oder mehreren Netzwerkknoten untergeordnet sind, abgelegt sind; eine dritte Ebene, in der eine oder mehrere Dateninstanzen abgelegt sind, die den einen oder mehreren Applikationen untergeordnet sind, wobei der zweite Datensatz Daten der ersten Ebene, der zweiten Ebene und der dritten Ebene der Baumstruktur des zweiten Netzwerkknotens umfasst.

In einer bevorzugten Ausführungsform wird der erste Hash bzw. der zweite Hash jeweils durch ein Hashkettenbasiertes Verfahren erzeugt, welches die folgenden Schritte umfasst:
Erzeugen eines Dateninstanz-Hashs für jede der einen oder mehreren Dateninstanzen, wobei der Dateninstanz-Hash durch eine Hash-Funktion erzeugt wird, welche die Dateninstanz als Eingabe nimmt;
Erzeugen eines Applikation-Hashs für jede der einen oder mehreren Applikationen, wobei der Applikation-Hash durch die Hash-Funktion erzeugt wird, welche die Information über die Applikation sowie alle Dateninstanz-Hashs einer oder mehrerer Dateninstanzen, die der Applikation untergeordnet sind, als Eingabe nimmt;
Erzeugen eines Knoten-Hashs für jeden der einen oder mehreren Netzwercknoten, wobei der Knoten-Hash durch die Hash-Funktion erzeugt wird, welche die Identifikation des Netzwerkknotens sowie alle Applikation-Hashs einer oder mehrerer Applikationen, die dem Netzwerkknoten untergeordnet sind, als Eingabe nimmt; und
Erzeugen des jeweiligen Hashs in der Wurzelebene des jeweiligen Knotens durch die Hash-Funktion, die alle Knoten-Hashs der einen oder mehreren Netzwerkknoten als Eingabe nimmt.

Es ist hier anzumerken, dass sich der erste Datensatz vorzugsweise auf Daten auf dem ersten Netzwerkknoten bezieht, die synchronisiert werden sollen, wobei der erste Datensatz alle oder nur einen Teil der Daten auf dem ersten Netzwerkknoten umfassen kann.

Analogerweise bezieht sich der zweite Datensatz vorzugsweise auf Daten auf dem zweiten Netzwerkknoten, die synchronisiert werden sollen, wobei der zweite Datensatz alle oder nur einen Teil der Daten auf dem zweiten Netzwerkknoten umfassen.

Somit kann mit der oben dargestellten Hashkette der Aufwand für die Erzeugung des ersten Hashs oder des zweiten Hashs in der Wurzelebene reduziert werden, da die Hash-Kette rekursive Hash-Berechnungen verwendet, um einen großen Datensatz in kleinere Teile zu unterteilen und diese zu hashen. Dieses Verfahren reduziert den Aufwand der Hash-Berechnung, da nicht der gesamte Datensatz wiederholt verarbeitet werden muss. Stattdessen werden Hashs für kleinere Teile der Daten berechnet und gespeichert. Diese Hashs werden kombiniert, um übergeordnete Hashs zu bilden, bis schließlich ein einziger Hash, wie beispielsweise der erste Hash oder der zweite Hash in der Wurzelebene, oder in anderen Worten ein Wurzelhash, übrigbleibt.

Dieses Verfahren ist besonders vorteilhaft, wenn Änderungen in einem kleinen Teil des jeweiligen Datensatzes für die Synchronisation vorkommen, wobei sie nur die Berechnung der betroffenen Hashs und deren übergeordneter Hashs erfordern, anstatt den gesamten Datensatz erneut hashen zu müssen.

Ein weiterer besonderer Vorteil besteht darin, dass mit Hilfe des Hashkettenbasierten Verfahrens auch Hashs für Teilmenge der Daten (durch Filter) erstellt werden können. Dies ermöglicht es beispielsweise, auf langsamen Übertragungsmedien nur bestimmte Applikationen zu synchronisieren. Anstatt den gesamten Datensatz zu übertragen, können durch gezielte Filterung relevante Daten ausgewählt werden. Dadurch wird die Effizienz verbessert und Ressourcen werden eingespart, insbesondere in Umgebungen mit begrenzter Bandbreite oder langsamen Netzwerkverbindungen.

In einer weiteren bevorzugten Ausführungsform umfasst der erste Datensatz und der zweite Datensatz jeweils eigene Daten des jeweiligen Netzwerkknotens und fremde Daten zumindest eines anderen Netzwerkknotens.

Die eigenen Daten des jeweiligen Netzwerkknotens beziehen sich auf Daten, die einen oder mehreren Applikationen auf dem jeweiligen Netzwerkknoten untergeordnet sind. In anderen Worten handelt es sich um Daten, die durch den Betrieb einer oder mehreren Applikationen auf dem jeweiligen Netzwercknoten entstanden sind, oder die eigenen Daten des jeweiligen Netzwerkknotens beziehen sich auf Daten, die in seinem eigenen Teilbaum, d.h. in dem Teilbaum mit der Identifikation des jeweiligen Netzwerkknotens, gespeichert sind.

Im Gegensatz dazu sind die fremden Daten des jeweiligen Netzwerkknotens vorzugsweise Daten, die von anderen Netzwerkknoten auf den jeweiligen Netzwerkknoten übertragen werden.

In einer bevorzugten Ausführungsform haben die eigenen Daten des jeweiligen Netzwerkknotens sowie fremde Daten von einem Netzwerkknoten innerhalb derselben Organisation wie der jeweilige Netzwerkknoten eine höhere Priorität bei der Übertragung durch den jeweiligen Netzwerkknoten als fremde Daten von einem Netzwerkknoten, der zu einer anderen Organisation gehört.

Das heißt, die eigenen Daten des ersten Netzwerkknotens sowie fremde Daten von einem Netzwerkknoten innerhalb derselben Organisation wie der erste Netzwerkknoten haben vorzugsweise eine höhere Priorität bei der Übertragung durch den ersten Netzwerkknoten als fremde Daten von einem Netzwerkknoten, der zu einer anderen Organisation gehört.

Analogerweise haben die eigenen Daten des zweiten Netzwerkknotens sowie fremde Daten von einem Netzwerkknoten innerhalb derselben Organisation wie der zweite Netzwerkknoten vorzugsweise eine höhere Priorität bei der Übertragung durch den zweiten Netzwerkknoten als fremde Daten von einem Netzwerkknoten, der zu einer anderen Organisation gehört.

Zusätzlich oder alternativ sollen nur fremde Daten akzeptiert werden, die von verifizierten Organisationen oder Netzwerkknoten stammen. Dies soll durch gängige Sicherheitsverfahren wie Zertifikate gewährleistet werden.

Vorzugsweise sind die eigenen Daten des jeweiligen Netzwerkknotens nur in einem Teilbaum der Baumstruktur geschrieben, der durch die Identifikation des jeweiligen Netzwerkknotens gekennzeichnet ist.

Auf diese Weise schreibt jeder Knoten die eigenen Daten nur in seinem eigenen Teilbaum, sodass die Daten auch ohne Quorum oder Locking konsistent sind.

Um Sicherheit zu gewährleisen, kann die Kommunikation zwischen dem ersten Knoten und dem zweiten Knoten durch Transport Layer Security, TLS, verschlüsselt werden.

In einer weiter bevorzugten Ausführungsform basiert die Kommunikation zwischen dem ersten Netzwerkknoten und dem zweiten Netzwerkknoten auf einem Public-Key-Infrastruktur, PKI, um die Synchronisation mit vertrauenswürdigen Netzwerkknoten zu ermöglichen.

Gemäß einem zweiten Aspekt der Erfindung wird die Aufgabe gelöst durch ein Verfahren, vorzugsweise ein Verfahren zur Datensynchronisation, durchgeführt von einem zweiten Netzwerkknoten oder ein Chipsystem für den zweiten Netzwerkknoten, umfassend: Empfangen einer Anfrage von einem ersten Netzwerkknoten, wobei die Anfrage einen Indikator umfasst, der einen ersten Datensatz auf dem ersten Netzwerkknoten indiziert; Bestimmen, auf Basis des Indikators, ob der erste Datensatz einen zweiten Datensatz auf dem zweiten Netzwerkknoten umfasst; Wenn nicht, umfasst das Verfahren ferner: Senden einer Antwort an den ersten Netzwerkknoten, wobei die Antwort einen dritten Datensatz umfasst, der einem vierten Datensatz auf dem zweiten Netzwerkknoten entspricht, wobei der vierte Datensatz eine Differenz zwischen dem zweiten Datensatz und dem ersten Datensatz umfasst, wobei der zweite Datensatz den vierten Datensatz umfasst.

Das Verfahren kann auch als ein Synchronisationsverfahren in einem Netzwerk verstanden werden, wobei das Netzwerk eine Mehrzahl von Netzwercknoten umfasst, welche den ersten Netzwerkknoten und den zweiten Netzwerkknoten umfasst.

Der zweite Netzwerkknoten ist vorzugsweise ein Nachbarknoten des ersten Netzwerkknoten, mit dem der erste Netzwerkknoten direkt, vorzugsweise ohne Relaisknoten, kommunizieren kann.

Die Anfrage kann auch als "Pull-Request" bezeichnet werden, da sie zum Ziel hat, Daten aus einem anderen Knoten zu "ziehen". Infolgedessen kann die Antwort als "Pull-Response" bezeichnet werden, da sie als eine Antwort auf die Anfrage, nämlich auf die "Pull-Request", verstanden werden kann. Durch diese Lösung werden Daten nur dann übertragen, wenn Unterschiede zwischen den Datensätzen auf zwei benachbarten Netzwerkknoten auftreten. Falls der erste Datensatz den zweiten Datensatz bereits enthält, ist eine Datenübertragung nicht notwendig. Dadurch können redundante Datenübertragungen vermieden werden, sodass Kommunikationsressourcen gespart werden.

Zudem wird mit dieser Lösung anstelle des gesamten zweiten Datensatzes auf dem zweiten Netzwerkknoten nur die Differenz zwischen dem zweiten Datensatz und dem ersten Datensatz übertragen. Auf diese Weise kann die Größe der zu übertragenden Daten erheblich reduziert werden, sodass die Effizienz der Datenübertragung gesteigert wird und die benötigte Bandbreite reduziert wird.

Mit dem obigen genannten Verfahren kann ein Datensatz von einem Netzwerkknoten auf einen benachbarten Netzwerkknoten übertragen werden. Falls jeder Netzwerkknoten in einem Netzwerk das Verfahren, vorzugsweise regelmäßig, durchführt, kann ein Datensatz schrittweise von einem Quellknoten zu einem Zielknoten propagiert werden, Knoten für Knoten.

In anderen Worten kann mit diesem Verfahren Daten zwischen allen benachbarten Knoten in einem Netzwerk synchronisiert werden, falls jeder Knoten in dem Netzwerk das Verfahren, vorzugsweise regelmäßig, durchführt, sodass Daten von einem Quellknoten zu einem Zielknoten schrittweise übertragen werden können.

Ein wesentlicher Vorteil dieser Lösung besteht darin, dass sie unabhängig von einer bestehenden funktionierenden Infrastruktur ist. Sie kann sowohl zur Ersetzung als auch zur Erweiterung vorhandener Infrastrukturen verwendet werden. Dies ermöglicht eine opportunistische Datentragung, die beispielsweise bei einem Ausfall stoppt und beim Wiederhochfahren der Infrastruktur nahtlos fortgesetzt wird, und zudem günstigste Gelegenheiten nutzt, die sich im Netzwerk ergeben, um Daten schrittweise, Knoten für Knoten, zu propagieren.

Ein weiterer Vorteil dieser Lösung liegt in der Möglichkeit der nahtlosen Integration in bestehende Technologie-Stacks. Eine auf dieser Lösung basierende Software fungiert hierbei als Speicher- und Datenaustauschplattform. Diese kann von Geräten oder anderer Software als Alternative zu Ende-zu-Ende Verbindungen genutzt werden. Eine Anbindung zwischen benachbarten Netzwerkknoten kann hierbei entweder über eine REST-API oder das Dateisystem erfolgen.

In einer bevorzugten Ausführungsform umfasst das Verfahren ferner folgende Schritte, bevor die Anfrage von dem ersten Netzwerkknoten empfangen wird: Empfangen eines ersten Hashs von dem ersten Netzwerkknoten, welcher auf Basis des ersten Datensatzes auf dem ersten Netzwerkknoten erzeugt ist; Erzeugen eines zweiten Hashs auf Basis des zweiten Datensatzes auf dem zweiten Netzwerkknoten; und Senden des zweiten Hashs an den ersten Netzwercknoten, falls der erste Hash und der zweite Hash unterschiedlich sind.

Mit dem Verfahren können Anfragen gespart werden, wenn Daten zwischen zwei benachbarten Netzwerkknoten gleich sind, oder bereits synchronisiert werden, sodass die Kommunikationseffizienz erhöht werden kann.

In einer Ausführungsform wird der erste Hash bzw. der zweite Hash jeweils durch eine Hash-Funktion erzeugt, die den ersten Datensatz bzw. den zweiten Datensatz als Eingabe nimmt.

In einer weiter bevorzugten Ausführungsform wird der erste Hash bzw. der zweite Hash jeweils durch ein Hashkettenbasiertes Verfahren erzeugt. Dieses Verfahren unterteilt den ersten Datensatz bzw. den zweiten Datensatz vorzugsweise in Teile und verwendet rekursive Hash-Berechnungen. Somit kann der Aufwand für die Erzeugung des ersten Hashs oder des zweiten Hashs reduziert werden. Dieses Verfahren wird im Folgenden noch weiter erläutert, insbesondere in Verbindung mit der Baumstruktur der Datenspeicherung.

In einer bevorzugten Ausführungsform wird der dritte Datensatz durch eine Komprimierung des vierten Datensatzes erzeugt.

Vorzugsweise umfasst die Komprimierung eine erste Komprimierung und/oder eine zweite Komprimierung. Die erste Komprimierung wird vorzugsweise auf Basis eines Referenzdatensatzes durchgeführt, wobei der Referenzdatensatz gemeinsame Daten zwischen dem ersten Datensatz und dem zweiten Datensatz umfasst. Die zweite Komprimierung basiert vorzugsweise auf dem Deflate- oder einem LZ-Algorithmus.

Durch die Nutzung gemeinsamer Daten als Referenzdatensatz zwischen Knoten können übereinstimmende Datenmuster in neuen Daten durch Verweise auf den Referenzdatensatz ersetzt werden. Dies bedeutet, dass, anstatt die tatsächlichen Datenmuster mehrfach zu übertragen, lediglich die Referenzen auf den bereits bekannten gemeinsamen Referenzdatensatz verwendet werden. Dadurch kann die Datenmenge erheblich reduziert.

Ein besonderer Vorteil dieses Ansatzes ist, dass kein separates Wörterbuch zur Komprimierung und anschließenden Dekomprimierung zwischen den Knoten übertragen werden muss. Normalerweise wird bei der Komprimierung ein Wörterbuch erstellt, dass sowohl dem sendenden als auch dem empfangenden Knoten bekannt sein muss. Durch die Verwendung eines gemeinsamen Referenzdatensatzes entfällt die Notwendigkeit, dieses Wörterbuch separat zu übertragen, was zusätzliche Bandbreite und Zeit spart.

Die Komprimierung umfasst vorzugsweise zwei Stufen. Zunächst wird eine erste Komprimierung unter Verwendung des Referenzdatensatzes durchgeführt, gefolgt von einer zweiten Komprimierung mit dem Deflate- oder einem Lempel-Ziv-, LZ-, Algorithmus, die die Datenmenge weiter reduzieren kann, wobei der LZ- oder Deflate-Algorithmus den Referenzdatensatz verwenden kann, um ein Preset Dictionary zwischen beiden Knoten zu erstellen und/oder zu trainieren.

Um unnötigen Komprimierungsaufwand zu vermeiden, wird in einer bevorzugten Ausführungsform die erste Komprimierung oder die zweite Komprimierung nur durchgeführt wird, bzw. das Ergebnis der ersten Komprimierung oder der zweiten Komprimierung nur übernommen, wenn festgestellt wird, dass die jeweilige Komprimierung Erfolg hat.

Das Feststellen des Erfolgs der jeweiligen Komprimierung umfasst vorzugsweise: Feststellen des Erfolgs der jeweiligen Komprimierung anhand eines Vergleichs zwischen der Zeit, die für die jeweilige Komprimierung benötigt wird, und einer geschätzten Übertragungszeit unkomprimierter Daten von dem zweiten Netzwerkknoten zu dem ersten Netzwerkknoten; und/oder Feststellen des Erfolgs der jeweiligen Komprimierung anhand eines Vergleichs zwischen der Datengröße vor und nach der jeweiligen Komprimierung.

Ferner umfasst die Antwort vorzugsweise ferner einen Komprimierungsindikator und einen Referenzdatenindikator, wobei der Komprimierungsindikator die Komprimierung indiziert, und der Referenzdatenindikator einen Referenzdatensatz indiziert. Somit kann der erste Netzwerkknoten den dritten Datensatz entsprechend dem Komprimierungsindikator und dem Referenzdatenindikator dekomprimieren, sodass der vierte Datensatz verlustfrei erhalten bleibt.

In einer weiteren bevorzugten Ausführungsform ist der zweite Netzwerkknoten dafür eingerichtet, mit dem ersten Netzwerkknoten opportunistisch zu kommunizieren.

Der wesentliche Vorteil dieser Lösung besteht darin, dass sie rudimentäre Kommunikationsmöglichkeiten auch in unterbrochenen und fragmentierten Netzen aufrechtzuerhalten kann. Dies ist besonders wichtig in Situationen, in denen keine Infrastruktur vorhanden ist oder diese aus verschiedenen Gründen nicht genutzt werden kann. Sie ermöglicht die Kommunikation in Umgebungen, in denen herkömmliche Netzwerke möglicherweise nicht verfügbar oder gestört sind. Dies ist insbesondere in Krisensituationen von großer Bedeutung.

In einer weiteren bevorzugten Ausführungsform erfolgt die Kommunikation zwischen dem ersten Netzwerkknoten und dem zweiten Netzwerkknoten durch IP-basierte Netzwerktechnologie, die vorzugsweise eine oder mehrere der folgenden Kommunikationswege verwendet: IEEE 802.11 , IEEE 802.3, ITU-T G.992/993, ITU-T G.9700/9701, ITU G.984 ITU-T Y.4480, 3G-6G mobile communication (3GPP). Es ist anzumerken, dass die hier erwähnten Kommunikationswege nur beispielhaft sind. Andere Kommunikationswege können ebenfalls verwendet werden. Die Erfindung ist diesbezüglich nicht beschränkt.

Eine Mehrzahl der Kommunikationswege kann kombiniert werden, um unterschiedliche Daten bestmöglich zu übertragen, ohne eine einzelne Verbindung zu überlasten. Dadurch ist die Lösung in DDIL-Umgebungen mit geringem Durchsatz und großer Reichweite, wie beispielsweise in militärischen und BOS-Umfeldern, einsetzbar.

Falls mehrere der Kommunikationswege gleichzeitig verfügbar sind, können sie je nach vorbestimmter Priorität ausgewählt werden. Die Priorisierung ermöglicht eine effiziente Kommunikation und Datenübertragung, um die gewünschte Quality of Service (QoS) sicherzustellen. Beispielsweise können die Kommunikationswege die folgenden Prioritäten besitzen: WiFi>Halow>LoRa.

In einer bevorzugten Ausführungsform sind der erste Datensatz und der zweite Datensatz jeweils in einer Baumstruktur gespeichert sind, wobei die Baumstruktur vier Ebenen umfasst: eine Wurzelebene, die den jeweilige Hash repräsentiert, der auf Basis des jeweiligen Datensatzes durch eine Hashfunktion generiert ist; eine erste Ebene, in welcher Identifikationen einer oder mehrerer Netzwerkknoten abgelegt sind, welche zumindest die Identifikation des Netzwerkknotens umfassen, auf dem der jeweilige Datensatz sich befindet; eine zweite Ebene, in der Informationen über eine oder mehrere Applikationen, die den einen oder mehreren Netzwerkknoten untergeordnet sind, abgelegt sind; eine dritte Ebene, in der eine oder mehrere Dateninstanzen abgelegt sind, die den einen oder mehreren Applikationen untergeordnet sind, wobei der jeweilige Datensatz Daten der ersten Ebene, der zweiten Ebene und der dritten Ebene der Baumstruktur umfasst.

In einer bevorzugten Ausführungsform umfasst das Erzeugen des jeweiligen Hashs in der Wurzelebene, nämlich das Erzeugen des ersten Hashs, oder das Erzeugen des zweiten Hashs, jeweils die folgenden Schritte:
Erzeugen eines Dateninstanz-Hashs für jede der einen oder mehreren Dateninstanzen, wobei der Dateninstanz-Hash durch eine Hash-Funktion erzeugt wird, welche die Dateninstanz als Eingabe nimmt;
Erzeugen eines Applikation-Hashs für jede der einen oder mehreren Applikationen, wobei der Applikation-Hash durch die Hash-Funktion erzeugt wird, welche die Information über die Applikation sowie alle Dateninstanz-Hashs einer oder mehrerer Dateninstanzen, die der Applikation untergeordnet sind, als Eingabe nimmt;
Erzeugen eines Knoten-Hashs für jeden der einen oder mehreren Netzwercknoten, wobei der Knoten-Hash durch die Hash-Funktion erzeugt wird, welche die Identifikation des Netzwerkknotens sowie alle Applikation-Hashs einer oder mehrerer Applikationen, die dem Netzwerkknoten untergeordnet sind, als Eingabe nimmt; und
Erzeugen des jeweiligen Hashs in der Wurzelebene des jeweiligen Knotens durch die Hash-Funktion, die alle Knotenhashs einen oder mehreren Netzwerkknoten als Eingabe nimmt.

Somit kann mit der oben dargestellten Hashkette der Aufwand für die Erzeugung des ersten Hashs oder des zweiten Hashs in der Wurzelebene reduziert werden, da die Hash-Kette rekursive Hash-Berechnungen verwendet, um einen großen Datensatz in kleinere Teile zu unterteilen und diese zu hashen. Dieses Verfahren reduziert den Aufwand der Hash-Berechnung, da nicht der gesamte Datensatz auf einmal verarbeitet werden muss. Stattdessen werden Hashs für kleinere Teile der Daten berechnet und gespeichert. Diese Hashs werden kombiniert, um übergeordnete Hashs zu bilden, bis schließlich ein einziger Hash, wie beispielsweise der erste Hash oder der zweite Hash in der Wurzelebene, oder in anderen Worten ein Wurzelhash, übrigbleibt.

Dieses Verfahren ist besonders vorteilhaft, wenn Änderungen in einem kleinen Teil des jeweiligen Datensatzes für die Synchronisation vorkommen, wobei sie nur die Berechnung der betroffenen Hashs und deren übergeordneter Hashs erfordern, anstatt den gesamten Datensatz erneut hashen zu müssen.

Ein weiterer besonderer Vorteil besteht darin, dass mit Hilfe des Hashkettenbasierten Verfahrens auch Hashs für Teilmenge der Daten (durch Filter) erstellt werden können. Dies ermöglicht es beispielsweise, auf langsamen Übertragungsmedien nur bestimmte Applikationen zu synchronisieren. Anstatt den gesamten Datensatz zu übertragen, können durch gezielte Filterung relevante Daten ausgewählt werden. Dadurch wird die Effizienz verbessert und Ressourcen werden eingespart, insbesondere in Umgebungen mit begrenzter Bandbreite oder langsamen Netzwerkverbindungen.

In einer weiteren bevorzugten Ausführungsform umfasst der jeweilige Datensatz eigene Daten des jeweiligen Netzwerkknotens und fremde Daten zumindest eines anderen Netzwerkknotens.

In einer bevorzugten Ausführungsform haben die eigenen Daten des jeweiligen Netzwerkknotens sowie fremde Daten von einem Netzwerkknoten innerhalb derselben Organisation wie der jeweilige Netzwerkknoten eine höhere Priorität bei der Übertragung durch den jeweiligen Netzwerkknoten als fremde Daten von einem Netzwerkknoten, der zu einer anderen Organisation gehört.

Zusätzlich oder alternativ sollen nur Daten von Knoten akzeptiert werden, die von verifizierten Organisationen stammen. Dies soll durch gängige Sicherheitsverfahren wie Zertifikate gewährleistet werden.

In einer weiteren bevorzugten Ausführungsform sind die eigenen Daten des jeweiligen Netzwerkknotens nur in einem Teilbaum der Baumstruktur geschrieben, der durch die Identifikation des jeweiligen Netzwerkknotens gekennzeichnet ist.

Gemäß einem dritten Aspekt wird die Aufgabe gelöst durch ein Verfahren, umfassend: Senden einer Anfrage an einen zweiten Netzwerkknoten durch einen ersten Netzwerkknoten, wobei die Anfrage einen Indikator umfasst, der einen ersten Datensatz auf dem ersten Netzwerkknoten indiziert; Empfangen der Anfrage von dem ersten Netzwerkknoten durch einen zweiten Netzwercknoten; Bestimmen, durch den zweiten Netzwerkknoten auf Basis des Indikators, ob der erste Datensatz einen zweiten Datensatz auf dem zweiten Netzwerkknoten umfasst; wenn der erste Datensatz den zweiten Datensatz nicht umfasst, umfasst das Verfahren ferner: Senden einer Antwort an den ersten Netzwerkknoten durch den zweiten Netzwerkknoten, wobei die Antwort einen dritten Datensatz umfasst, der einem vierten Datensatz auf dem zweiten Netzwerkknoten entspricht, wobei der vierte Datensatz eine Differenz zwischen dem zweiten Datensatz und dem ersten Datensatz umfasst, wobei der zweite Datensatz den vierten Datensatz umfasst; Empfangen der Antwort von dem zweiten Netzwerkknoten durch den ersten Netzwerkknoten; und Speichern des vierten Datensatzes auf dem ersten Netzwerkknoten auf Basis der Antwort durch den ersten Netzwerkknoten.

Gemäß einem vierten Aspekt der Erfindung wird die Aufgabe gelöst durch einen ersten Netzwerkknoten, welcher dafür eingerichtet ist, das Verfahren gemäß dem ersten Aspekt oder einer dem ersten Aspekt zugehörigen Ausführungsform durchzuführen.

Gemäß einem fünften Aspekt der Erfindung wird die Aufgabe gelöst durch einen zweiten Netzwerkknoten, welcher dafür eingerichtet ist, das Verfahren gemäß dem zweiten Aspekt oder einer dem zweiten Aspekt zugehörigen Ausführungsform durchzuführen.

Gemäß einem sechsten Aspekt der Erfindung wird die Aufgabe gelöst durch ein Netzwerk, welches einen ersten Netzwerkknoten gemäß dem vierten Aspekt und einen zweiten Netzwerkknoten gemäß dem fünften Aspekt umfasst.

Gemäß einem siebten Aspekt der Erfindung wird die Aufgabe gelöst durch einen Netzwerkknoten, welcher nicht nur dafür eingerichtet ist, das Verfahren gemäß dem ersten Aspekt oder einer dem ersten Aspekt zugehörigen Ausführungsform durchzuführen, sondern auch dafür eingerichtet ist, das Verfahren gemäß dem zweiten Aspekt oder einer dem zweiten Aspekt zugehörigen Ausführungsform durchzuführen.

Wenn der Netzwerkknoten das Verfahren gemäß dem ersten Aspekt oder einer dem ersten Aspekt zugehörigen Ausführungsform durchführt, fungiert der Netzwerkknoten als der erste Netzwerkknoten, sodass ein anderer Netzwercknoten, vorzugsweise ein benachbarter Netzwerkknoten des Netzwerkknotens, als der zweiter Netzwerkknoten fungiert. Wenn der Netzwerkknoten das Verfahren gemäß dem zweiten Aspekt oder einer dem zweiten Aspekt zugehörigen Ausführungsform durchführt, fungiert der Netzwerkknoten als der zweite Netzwerkknoten, sodass ein anderer Netzwerkknoten, vorzugsweise ein benachbarter Netzwerkknoten des Netzwerkknotens, als der erste Netzwerkknoten fungiert.

In anderen Worten ist jeder Netzwerkknoten in dem Netzwerk vorzugsweise dafür eingerichtet, nicht nur Daten aus benachbarten Netzwerkknoten zu ziehen, sondern auch die auf ihm gespeicherten Daten auf anderen Netzwercknoten zu übertragen, wodurch eine Synchronisierung der Daten zwischen allen Netzwerkknoten in dem Netzwerk erreicht werden kann.

Gemäß einem achten Aspekt der Erfindung wird die Aufgabe gelöst durch ein Netzwerk, wobei das Netzwerk einen Netzwerkknoten gemäß dem siebten Aspekt umfasst.

Gemäß einem neunten Aspekt der Erfindung wird die Aufgabe gelöst durch ein computerlesbares Medium, umfassend Befehle, die bei der Ausführung durch einen Computer diesen veranlassen, gemäß dem ersten Aspekt oder einer dem ersten Aspekt zugehörigen Ausführungsform, und/oder das Verfahren gemäß dem zweiten Aspekt oder einer dem zweiten Aspekt zugehörigen Ausführungsform durchzuführen.

Gemäß einem zehnten Aspekt der Erfindung wird die Aufgabe gelöst durch ein Computerprogrammprodukt, umfassend Befehle, die bei der Ausführung durch einen Computer diesen veranlassen, das Verfahren gemäß dem ersten Aspekt oder einer dem ersten Aspekt zugehörigen Ausführungsform, und/oder das Verfahren gemäß dem zweiten Aspekt oder einer dem zweiten Aspekt zugehörigen Ausführungsform durchzuführen.

Gemäß einem elften Aspekt der Erfindung wird die Aufgabe gelöst durch ein Chipsystem, welcher dafür eingerichtet ist, das Verfahren gemäß dem ersten Aspekt oder einer dem ersten Aspekt zugehörigen Ausführungsform, und/oder das Verfahren gemäß dem zweiten Aspekt oder einer dem zweiten Aspekt zugehörigen Ausführungsform durchzuführen.

Die Erfindung wird nachfolgend anhand bevorzugter Ausführungsbeispiele unter Bezugnahme auf die beigefügten Zeichnungen näher erläutert. Es zeigen:
- Fig. 1: Eine schematische Darstellung eines Netzwerks gemäß einer Ausführungsform der Erfindung,
- Fig. 2: Eine schematische Darstellung eines Datenübertragungsprozesses von einem Netzwerkknoten auf einen anderen Netzwercknoten gemäß einer Ausführungsform der Erfindung,
- Fig. 3: Eine schematische Darstellung eines Beispiels für eine Datenkomprimierung unter Verwendung eines Referenzdatensatzes gemäß einer Ausführungsform der Erfindung,
- Fig. 4: Ein Venn-Diagramm für die schematische Darstellung verschiedener Datensätze gemäß einer Ausführungsform der Erfindung,
- Fig. 5: Eine schematische Darstellung einer Datenspeicherung in einer Baumstruktur auf Knoten 1 gemäß einer Ausführungsform der Erfindung,
- Fig. 6: Eine schematische Darstellung einer Datenspeicherung in einer Baumstruktur auf Knoten 1 gemäß einer Ausführungsform der Erfindung,
- Fig. 7: Eine schematische Darstellung einer Datenspeicherung in einer Baumstruktur auf Knoten 1 gemäß einer Ausführungsform der Erfindung,
- Fig. 8: Eine schematische Darstellung einer ersten Phase eines Datensynchronisationsprozesses zwischen zwei Knoten gemäß einer Ausführungsform der Erfindung,
- Fig. 9: Eine schematische Darstellung einer zweiten Phase eines Datensynchronisationsprozesses zwischen zwei Knoten gemäß einer Ausführungsform der Erfindung,
- Fig. 10: Eine schematische Darstellung einer dritten Phase eines Datensynchronisationsprozesses zwischen zwei Knoten gemäß einer Ausführungsform der Erfindung,
- Fig. 11: Eine schematische Darstellung einer vierten Phase eines Datensynchronisationsprozesses zwischen zwei Knoten gemäß einer Ausführungsform der Erfindung,
- Fig. 12: Eine schematische Darstellung einer fünften Phase eines Datensynchronisationsprozesses zwischen zwei Knoten gemäß einer Ausführungsform der Erfindung,
- Fig. 13: Eine schematische Darstellung einer sechsten Phase eines Datensynchronisationsprozesses zwischen zwei Knoten gemäß einer Ausführungsform der Erfindung.

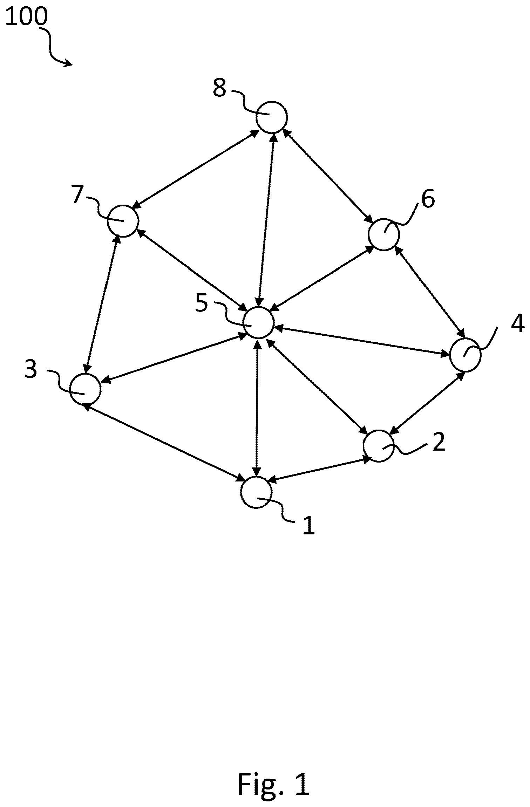

Fig. 1 zeigt ein Netzwerk 100 gemäß einer Ausführungsform der vorliegenden Erfindung, wobei das Netzwerk 100 eine Mehrzahl von Netzwerkknoten umfasst, wobei jeder Netzwerkknoten einen oder mehrere benachbarten Netzwerkknoten hat, mit dem der Netzwerkknoten direkt kommunizieren kann. Ein Netzwerkknoten ist beispielsweise ein Computer oder ein Server, der nicht nur in der Lage ist, Daten zu senden und zu empfangen, aber auch dafür eingerichtet ist, Daten zu speichern und zu verarbeiten. Ein Netzwerkgerät, das nur Daten weiterleitet, wie beispielsweise ein Router oder ein Switch, wird im Rahmen dieser Erfindung nicht als einen Netzwerkknoten betrachtet.

Im Folgenden wird der Einfachheit halber ein Netzwerkknoten auch als Knoten bezeichnet.

Fig. 1 zeigt beispielhaft acht Knoten 1-8, wobei jeder Knoten dafür eingerichtet ist, mit einem oder mehreren Nachbarknoten direkt, vorzugsweise ohne einen Relaisknoten, zu kommunizieren. Beispielsweise sind Knoten 2, 3, 5 Nachbarknoten von Knoten 1, wobei Knoten 4, 6, 7 und 8 keine Nachbarknoten von Knoten 1 sind, da sie nicht direkt, sondern nur über weitere Knoten mit Knoten 1 kommunizieren können.

Das Netzwerk befindet sich beispielhaft in einer DDIL-Umgebung, die durch Störungen, regelmäßige Unterbrechungen und niedrige Bandbreiten gekennzeichnet sind, sodass eine durchgängige und zuverlässige Ende-zu-Ende-Verbindung über sämtliche Netzwerksegmente schwer zu gewährleisten ist.

Um das Problem zu lösen, wird in einer Ausführungsform der Erfindung jeder Knoten dafür eingerichtet, Daten mit jedem benachbarten Knoten zu synchronisieren, wobei der Knoten vorzugsweise nicht nur dafür eingerichtet ist, Daten aus benachbarten Netzwerkknoten zu ziehen, sondern auch die auf ihm gespeicherten Daten auf anderen Netzwerkknoten zu übertragen, wodurch eine Synchronisierung der Daten zwischen allen Netzwerkknoten in dem Netzwerk erreicht werden kann.

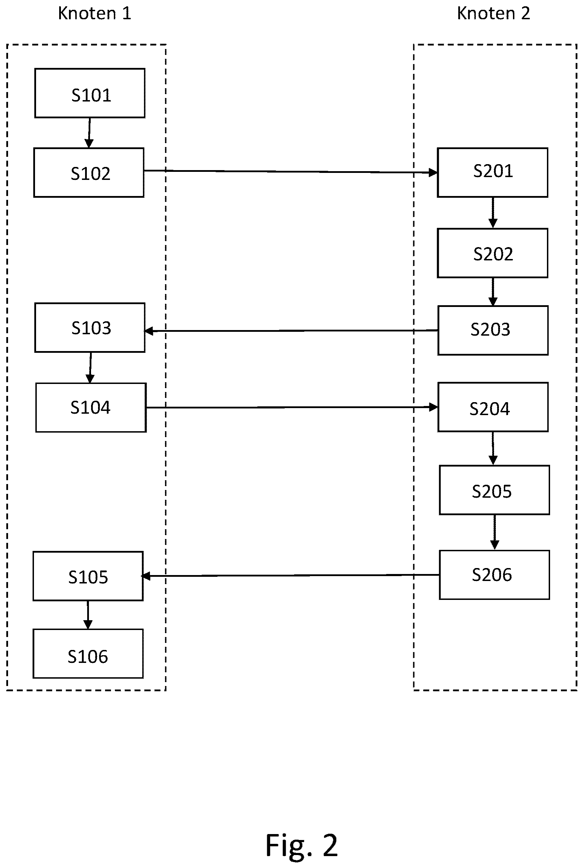

In der in Fig. 2 dargestellte Ausführungsform der Erfindung wird anhand eines Beispiels zwischen Knoten 1 und Knoten 2 erklärt, wie Daten von einem Knoten auf einen benachbarten Knoten synchronisiert werden.

Das in Fig. 2 dargestellte Verfahren umfasst vorzugsweise die folgenden Schritte:
S101: Knoten 1 erzeugt einen ersten Hash auf Basis eines ersten Datensatzes auf Knoten 1.

Der erste Datensatz kann alle oder nur einen Teil der Daten auf Knoten 1 umfassen. Der erste Datensatz bezieht sich vorzugsweise auf Daten, die synchronisiert werden sollen.

Ein Hash ist das Ergebnis einer Hash-Funktion, die eine beliebige Eingabe nimmt und eine feste Länge an Zeichen erzeugt.

In einer Ausführungsform kann der erste Hash durch eine Hash-Funktion erzeugt werden, der den ersten Datensatz als Eingabe nimmt.

In einer weiter bevorzugten Ausführungsform wird der erste Hash durch ein Hashkettenbasiertes Verfahren erzeugt. Dieses Verfahren unterteilt den ersten Datensatz vorzugsweise in Teile und verwendet rekursive Hash-Berechnungen. Somit kann der Aufwand für die Erzeugung des ersten Hashs reduziert werden. Dieses Verfahren wird im Folgenden noch weiter erläutert, insbesondere in Verbindung mit der Baumstruktur der Datenspeicherung.

S102: Knoten 1 broadcastet den ersten Hash an einen oder mehrere Knoten, welche Knoten 2 umfassen.

Vorzugsweise wird ein erster Hash auf Basis eines ersten Datensatzes auf Knoten 1 regelmäßig erzeugt und gebroadcastet.

Die einer oder mehreren Knoten sind vorzugsweise Nachbarknoten von Knoten 1, wie beispielsweise die in Fig. 1 gezeigten Knoten 2, 3 und 5. Im Folgenden wird der Einfachheit halber nur die Kommunikation zwischen Knoten 1 und Knoten 2 dargestellt. Es ist allerdings anzumerken, dass Knoten 3 und Knoten 5 ebenfalls dafür eingerichtet sind, die gleichen Schritte wie Knoten 2, die im Folgenden dargestellt werden, durchzuführen.

S201: Knoten 2 empfängt den ersten Hash.

S202: Knoten 2 erzeugt einen zweiten Hash auf Basis eines zweiten Datensatzes auf Knoten 2.

Der zweite Datensatz kann alle oder nur einen Teil der Daten auf Knoten 2 umfassen. Der zweite Datensatz bezieht sich vorzugsweise auf Daten, die synchronisiert werden sollen.

In einer Ausführungsform wird der zweite Hash durch eine Hash-Funktion erzeugt, der den zweiten Datensatz als Eingabe nimmt, wobei die Hash-Funktion vorzugsweise die gleiche Hash-Funktion, die Knoten 1 zur Erzeugung des ersten Hashs verwendet.

In einer weiter bevorzugten Ausführungsform wird der zweite Hash durch ein Hashkettenbasiertes Verfahren erzeugt. Dieses Verfahren unterteilt den zweiten Datensatz vorzugsweise in Teile und verwendet rekursive Hash-Berechnungen. Somit kann der Aufwand für die Erzeugung des zweiten Hashs reduziert werden. Dieses Verfahren wird im Folgenden noch weiter erläutert, insbesondere in Verbindung mit der Baumstruktur der Datenspeicherung.

S203: Knoten 2 sendet den zweiten Hash an den ersten Netzwerkknoten, falls der erste Hash und der zweite Hash unterschiedlich sind.

Wenn der erste Hash und der zweite Hash gleich sind, bedeutet es, dass der erste Datensatz und der zweite Datensatz gleich sind, oder bereits synchronisiert worden sind, sodass eine Datenübertragung zwischen Knoten 1 und Knoten 2 zur Datensynchronisation nicht erforderlich ist.

S103: Knoten 1 empfängt den zweiten Hash.

S104: Knoten 1 sendet eine Anfrage an den Knoten 2, wobei die Anfrage einen Indikator umfasst, der den ersten Datensatz auf dem Knoten 1 indiziert.

Die Anfrage kann auch als "Pull-Request" bezeichnet werden, da sie zum Ziel hat, Daten aus einem anderen Knoten zu "ziehen".

S204: Knoten 2 empfängt die Anfrage von Knoten 1.

S205: Knoten 2 bestimmt, auf Basis des Indikators, ob der erste Datensatz den zweiten Datensatz bereits umfasst.

Falls es bestimmt wird, dass der erste Datensatz den zweiten Datensatz bereits umfasst, ist es nicht erforderlich, den zweiten Datensatz nochmals auf Knoten 1 zu übertragen.

S206: Falls es bestimmt wird, dass der erste Datensatz den zweiten Datensatz nicht umfasst, sendet Knoten 2 eine Antwort an Knoten 1, wobei die Antwort einen dritten Datensatz umfasst, der einem vierten Datensatz auf dem zweiten Netzwerkknoten entspricht, wobei der vierte Datensatz eine Differenz zwischen dem zweiten Datensatz und dem ersten Datensatz umfasst, wobei der zweite Datensatz den vierten Datensatz umfasst.

Somit kann anstelle des gesamten zweiten Datensatzes auf Knoten 2 nur die Differenz zwischen dem zweiten Dateninstanz und dem ersten Dateninstanz übertragen werden. Auf diese Weise kann die Größe der zu übertragenden Daten erheblich reduziert werden, sodass die Effizienz der Datenübertragung gesteigert wird und die benötigte Bandbreite reduziert wird.

Vorzugsweise wird der dritte Datensatz durch eine Komprimierung des vierten Datensatzes erzeugt, sodass die Datenmenge weiter reduziert werden kann.

Die Komprimierung umfasst vorzugsweise eine erste Komprimierung und/oder eine zweite Komprimierung. Die erste Komprimierung wird vorzugsweise auf Basis eines Referenzdatensatzes durchgeführt, wobei der Referenzdatensatz gemeinsame Daten zwischen dem ersten Datensatz und dem zweiten Datensatz umfasst. Die zweite Komprimierung basiert vorzugsweise auf dem Deflate- oder einem LZ-Algorithmus.

Durch die Nutzung gemeinsamer Daten als Referenzdatensatz zwischen Knoten können übereinstimmende Datenmuster in neuen Daten durch Verweise auf den Referenzdatensatz ersetzt werden. Dies bedeutet, dass, anstatt die tatsächlichen Datenmuster mehrfach zu übertragen, lediglich die Referenzen auf den bereits bekannten gemeinsamen Referenzdatensatz verwendet werden. Dadurch kann die Datenmenge erheblich reduziert werden.

Ein besonderer Vorteil dieses Ansatzes ist, dass kein separates Wörterbuch zur Komprimierung und anschließenden Dekomprimierung zwischen den Knoten übertragen werden muss. Normalerweise wird bei der Komprimierung ein Wörterbuch erstellt, das sowohl dem sendenden als auch dem empfangenden Knoten bekannt sein muss. Durch die Verwendung eines gemeinsamen Referenzdatensatzes entfällt die Notwendigkeit, dieses Wörterbuch separat zu übertragen, was zusätzliche Bandbreite und Zeit spart.

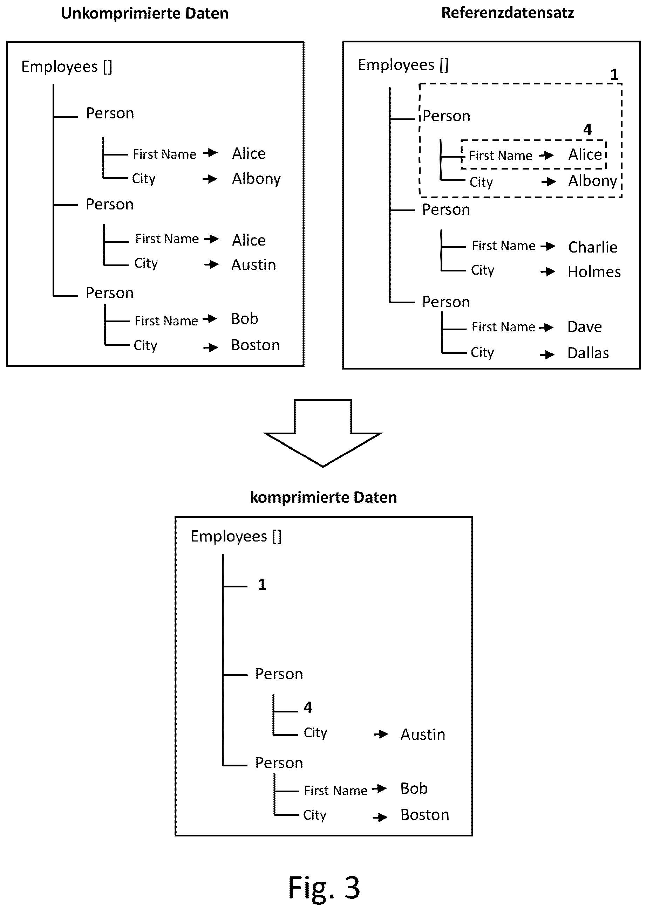

Eine Komprimierung unter Verwendung eines Referenzdatensatzes kann wie folgt ablaufen. Einträge in einem zu komprimierenden Datensatz werden durch Verweise auf Einträge im Referenzdatensatz ersetzt. Hierzu werden vorzugsweise beide Datensätze jeweils rekursiv durchlaufen und zu allen Datenfeldern ein Eintrag in einer sortierten Liste eingetragen. Zur Ersetzung einzelner Teile des zu komprimierenden Datensatzes dienen als Verweise die Positionen der einzelnen Teile in der sortierten Liste des Referenzdatensatzes. Hierzu werden vorzugsweise zuerst möglichst große Teilbereiche bis runter zu einzelnen Datenfelder durch Verweise ersetzt. Zum Beispiel haben die in Fig. 3 durch gestrichelte Rechtecke markierten Datenblöcke die Positionen 1 und 4 in der sortierten Liste des Referenzdatensatzes. Diese Datenblöcke im zu komprimierenden Datensatz können daher durch ihre Positionen 1 und 4 ersetzt werden, wodurch eine Komprimierung erzielt wird.

Falls auf der Gegenseite der gleiche Referenzdatensatz zur Verfügung steht und mit dem gleichen Verfahren durchlaufen wird, sodass eine identische sortierten Liste des Referenzdatensatzes entsteht, können in der Dekompression die Verweise aus der sortierten Liste des Referenzdatensatzes ersetzt und das Original so wieder zusammengesetzt werden.

Die Komprimierung umfasst vorzugsweise zwei Stufen. Zunächst wird eine erste Komprimierung unter Verwendung des Referenzdatensatzes durchgeführt, wie vorherdargestellt, gefolgt von einer zweiten Komprimierung mit dem Deflate- oder einem Lempel-Ziv-, LZ-, Algorithmus, die die Datenmenge weiter reduzieren kann, wobei der Deflate- oder LZ-Algorithmus vorzugsweise den Referenzdatensatz wieder verwenden kann, um ein Preset Dictionary zwischen beiden Knoten zu erstellen und/oder zu trainieren.

Ein Preset Dictionary (auch als vordefiniertes Wörterbuch bekannt) auf eine vorab festgelegte Sammlung von Zeichenketten oder Datenmustern, die häufig in der zu komprimierenden Datenart vorkommen. Dieses Wörterbuch wird verwendet, um die Komprimierungseffizienz zu erhöhen, insbesondere bei Daten, die viele Wiederholungen enthalten.

Beim Komprimieren von Daten kann der Kompressor das vordefinierte Wörterbuch verwenden, um häufige Muster durch kürzere Verweise zu ersetzen und somit die Größe der Ausgabedatei zu reduzieren. Beim Dekomprimieren verwendet der Dekompressor dasselbe Preset Dictionary, um diese Verweise zu interpretieren und die ursprünglichen Daten wiederherzustellen.

In einer bevorzugten Ausführungsform der Erfindung verwendet der LZ- oder Deflate-Algorithmus wieder den Referenzdatensatz, um das Preset Dictionary zwischen beiden Netzwerkknoten zu generieren und/oder durch Training zu optimieren.

Da sich der Referenzdatensatz, also die gemeinsamen Daten zwischen beiden Netzwerkknoten, ändern können, kann das Preset Dictionary dynamisch gestaltet werden, indem es regelmäßig an die aktuellen Datenmuster angepasst wird. Dies führt zu einem dynamischen Preset Dictionary, das laufend mit der Änderung des Referenzdatensatzes aktualisiert wird.

Um unnötigen Komprimierungsaufwand zu vermeiden, wird vorzugsweise die erste Komprimierung oder die zweite Komprimierung nur durchgeführt, bzw. das Ergebnis der ersten Komprimierung oder der zweiten Komprimierung nur übernommen, wenn festgestellt wird, dass die jeweilige Komprimierung Erfolg hat.

Das Feststellen des Erfolgs der jeweiligen Komprimierung umfasst vorzugsweise: Feststellen des Erfolgs der jeweiligen Komprimierung anhand eines Vergleichs zwischen der Zeit, die für die jeweilige Komprimierung benötigt wird, und einer geschätzten Übertragungszeit für unkomprimierte Daten. Falls die Zeit für die jeweilige Komprimierung länger ist als die Übertragungszeit für unkomprimierte Daten, übersteigt der Aufwand für die Komprimierung offensichtlich den Nutzen, sodass es nicht sinnvoll ist, die Daten zu komprimieren.

Zusätzlich oder alternativ umfasst das Feststellen des Erfolgs der jeweiligen Komprimierung anhand eines Vergleichs zwischen der Datengröße vor und nach der jeweiligen Komprimierung. Wenn die Größe der komprimierten Daten nicht kleiner als die Größe der ursprünglichen Daten ist, gilt die Komprimierung als nicht erfolgreich, sodass das Ergebnis der Komprimierung verworfen wird.

Falls der dritte Datensatz ein komprimierter Datensatz ist, umfasst die Antwort vorzugsweise ferner einen Komprimierungsindikator und einen Referenzdatenindikator, wobei der Komprimierungsindikator die Komprimierung indiziert, und der Referenzdatenindikator den Referenzdatensatz indiziert. Der Komprimierungsindikator weist vorzugsweise auf ein oder mehrere verwendeten Komprimierungsverfahren, beispielsweise die erste Komprimierung und/oder die zweite Komprimierung.

Durch den Komprimierungsindikator und den Referenzdatenindikator ist Knoten 1 in der Lage, die empfangenen Daten entsprechend zu dekomprimieren, sodass der vierte Datensatz verlustfrei erhalten bleibt.

Bevor der vierte Datensatz komprimiert wird, kann er, wie auch der Referenzdatensatz, in das binäre CBOR (binäre Concise Binary Object Representation)-Format serialisiert werden. CBOR ist ein an JSON (JavaScript Object Notation) angelehntes Binärformat, wobei CBOR im Vergleich zu textbasiertem JSON kompakter ist, was zu geringeren Speicher- und Übertragungskosten führt.

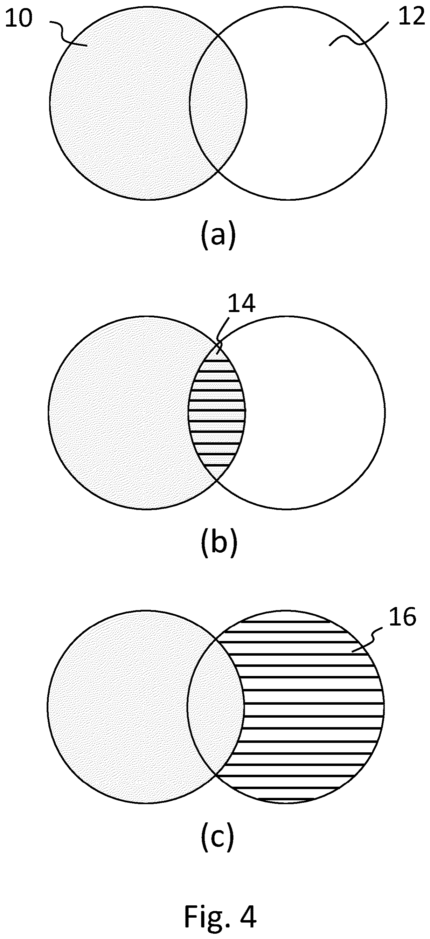

In Fig. 4 ist ein Venn-Diagramm dargestellt, das die Beziehungen zwischen den oben genannten Datensätzen beispielhaft zeigt. In Teilfigur (a) sind ein erster Datensatz 10 auf Knoten 1 und ein zweiter Datensatz 12 auf Knoten 2 jeweils durch einen Kreis dargestellt. Es ist zu erkennen, dass der erste Datensatz 10 und der zweite Datensatz 12 eine Schnittmenge 14 haben, die in Teilfigur (b) schattiert gezeigt ist. Das bedeutet, dass der Datensatz 14 gemeinsame Daten zwischen dem ersten Datensatz 10 und dem zweiten Datensatz 12 umfasst. Der Datensatz 14 bezieht sich vorzugsweise auf den oben diskutierten Referenzdatensatz.

Der Datensatz 16, der in Teilfigur (c) schattiert dargestellt ist, repräsentiert beispielhaft den oben diskutierten vierten Datensatz. Es ist zu erkennen, dass der vierte Datensatz 16 eine Differenz zwischen dem zweiten Datensatz 12 und dem ersten Datensatz 10 umfasst, wobei der zweite Datensatz 12 den vierten Datensatz 16 umfasst.

Für die Synchronisation des vierten Datensatzes 16 von Knoten 2 auf Knoten 1 wird er vorzugsweise in einen dritten Datensatz komprimiert. Die oben diskutierte Antwort von Knoten 2 an Knoten 1, die auch als "Pull-Response" bezeichnet wird, umfasst diesen dritten Datensatz. Die Komprimierung umfasst, wie bereits diskutiert, vorzugsweise eine erste Komprimierung unter Verwendung des Referenzdatensatzes 14, gefolgt von einer zweiten Komprimierung mit dem Deflate- oder Lempel-Ziv-, LZ-, Algorithmus, die die Datenmenge weiter reduzieren kann, wobei der Deflate- oder LZ-Algorithmus den Referenzdatensatz 14 verwenden kann, um ein Preset Dictionary für die Komprimierung und die Dekomprimierung zu erstellen und/oder trainieren.

S105: Knoten 1 empfängt die Antwort des zweiten Netzwerkknoten.

S106: Knoten 1 speichert den vierten Datensatz auf Basis der Antwort, die den dritten Datensatz umfasst.

Das Speichern des vierten Datensatzes auf Basis der Antwort umfasst vorzugsweise: Dekomprimieren des dritten Datensatzes, um den vierten Datensatz zu erhalten; und Speichern des vierten Datensatzes auf Knoten 1.

Vorzugsweise umfasst das Dekomprimieren des dritten Datensatzes: Dekomprimieren des dritten Datensatzes auf Basis eines Referenzdatensatzes und/oder auf Basis des Deflate- oder Lempel-Ziv-, LZ-, Algorithmus, wobei der Referenzdatensatz gemeinsame Daten zwischen dem ersten Datensatz und dem zweiten Datensatz umfasst. Ein LZ-Algorithmus kann beispielsweise ein LZ77-, ein LZ78-, ein LZMA-, ein LZSS- oder ein LZW-Algorithmus sein.

Da die Komprimierung in zwei Stufen erfolgen kann, kann die Dekomprimierung entsprechend ebenfalls in zwei Stufen durchgeführt werden. Zunächst wird vorzugsweise eine erste Dekomprimierung mit dem Deflate- oder einem LZ-, Algorithmus durchgeführt, gefolgt von einer zweiten Dekomprimierung unter Verwendung des Referenzdatensatzes.

Es wird an dieser Stelle darauf hingewiesen, dass Schritte S101, S102, S103, S201, S202, S203 optional sind. Das bedeutet, dass das Verfahren auch ohne einen Austausch der Hash-Werte zwischen Knoten durchgeführt werden kann.

In einer bevorzugten Ausführungsform sind der erste Datensatz und der zweite Datensatz jeweils in einer Baumstruktur gespeichert, wobei die Baumstruktur vier Ebenen umfasst: eine Wurzelebene, die den jeweilige Hash repräsentiert, der auf Basis des jeweiligen Datensatzes durch eine Hashfunktion generiert ist; eine erste Ebene, in welcher Identifikationen einer oder mehrerer Netzwerkknoten abgelegt sind, welche zumindest die Identifikation des Netzwerkknotens umfassen, auf dem der jeweilige Datensatz sich befindet; eine zweite Ebene, in der Informationen über eine oder mehrere Applikationen, die den einen oder mehreren Netzwerkknoten untergeordnet sind, abgelegt sind; eine dritte Ebene, in der eine oder mehrere Dateninstanzen abgelegt sind, die den einen oder mehreren Applikationen untergeordnet sind, wobei der jeweilige Datensatz Daten der ersten Ebene, der zweiten Ebene und der dritten Ebene der Baumstruktur umfasst.

In einer bevorzugten Ausführungsform umfasst das Erzeugen des jeweiligen Hashs in der Wurzelebene, nämlich das Erzeugen des ersten Hashs in Schritt S101, oder das Erzeugen des zweiten Hashs in Schritt S202, jeweils die folgenden Schritte:
Erzeugen eines Dateninstanz-Hashs für jede der einen oder mehreren Dateninstanzen, wobei der Dateninstanz-Hash durch eine Hash-Funktion erzeugt wird, welche die Dateninstanz als Eingabe nimmt;
Erzeugen eines Applikation-Hashs für jede der einen oder mehreren Applikationen, wobei der Applikation-Hash durch die Hash-Funktion erzeugt wird, welche die Information über die Applikation sowie alle Dateninstanz-Hashs einer oder mehrerer Dateninstanzen, die der Applikation untergeordnet sind, als Eingabe nimmt;
Erzeugen eines Knoten-Hashs für jeden der einen oder mehreren Netzwercknoten, wobei der Knoten-Hash durch die Hash-Funktion erzeugt wird, welche die Identifikation des Netzwerkknotens sowie alle Applikation-Hashs einer oder mehrerer Applikationen, die dem Netzwerkknoten untergeordnet sind, als Eingabe nimmt; und
Erzeugen des jeweiligen Hashs in der Wurzelebene des jeweiligen Knotens durch die Hash-Funktion, die alle Knotenhashs der einen oder mehreren Netzwerkknoten als Eingabe nimmt.

Somit kann mit der oben dargestellten Hashkette der Aufwand für die Erzeugung des ersten Hashs oder des zweiten Hashs in der Wurzelebene reduziert, da die Hash-Kette rekursive Hash-Berechnungen verwendet, um einen großen Datensatz in kleinere Teile zu unterteilen und diese zu hashen. Dieses Verfahren reduziert den Aufwand der Hash-Berechnung, da nicht der gesamte Datensatz auf einmal verarbeitet werden muss.

Stattdessen werden Hashs für kleinere Teile der Daten berechnet und gespeichert. Diese Hashs werden kombiniert, um übergeordnete Hashs zu bilden, bis schließlich ein einziger Hash, wie beispielsweise der erste Hash oder der zweite Hash in der Wurzelebene, oder in anderen Worten ein Wurzelhash, übrigbleibt.

Dieses Verfahren ist besonders vorteilhaft, wenn Änderungen in einem kleinen Teil des jeweiligen Datensatzes für die Synchronisation vorkommen, wobei sie nur die Berechnung der betroffenen Hashs und deren übergeordneter Hashs erfordern, anstatt den gesamten Datensatz erneut zu hashen.

Ein weiterer besonderer Vorteil besteht darin, dass mit Hilfe des Hashkettenbasierten Verfahrens auch Hashs für Teilmenge der Daten (durch Filter) erstellt werden können. Dies ermöglicht es beispielsweise, auf langsamen Übertragungsmedien nur bestimmte Applikationen zu synchronisieren. Anstatt den gesamten Datensatz zu übertragen, können durch gezielte Filterung relevante Daten ausgewählt werden. Dadurch wird die Effizienz verbessert und Ressourcen werden eingespart, insbesondere in Umgebungen mit begrenzter Bandbreite oder langsamen Netzwerkverbindungen.

Zudem kann der jeweilige Datensatz eigene Daten des jeweiligen Netzwercknotens und fremde Daten zumindest eines anderen Netzwerkknotens umfassen.

Die eigenen Daten des jeweiligen Netzwerkknotens beziehen sich auf Daten, die einen oder mehreren Applikationen auf dem jeweiligen Netzwerkknoten untergeordnet sind. In anderen Worten handelt es sich um Daten, die durch den Betrieb einer oder mehreren Applikationen auf dem jeweiligen Netzwercknoten entstanden sind, oder die eigenen Daten des jeweiligen Netzwerkknotens beziehen sich auf Daten, die in seinem eigenen Teilbaum, d.h. in dem Teilbaum mit der Identifikation des jeweiligen Netzwerkknotens, abgespeichert sind.

Im Gegensatz dazu sind die fremden Daten des jeweiligen Netzwerkknotens vorzugsweise Daten, die von anderen Netzwerkknoten auf den jeweiligen Netzwerkknoten übertragen werden.

In einer bevorzugten Ausführungsform haben die eigenen Daten sowie fremde Daten von einem Netzwerkknoten innerhalb derselben Organisation wie der jeweilige Netzwerkknoten eine höhere Priorität bei der Übertragung durch den jeweiligen Netzwerkknoten als fremde Daten von einem Netzwercknoten, der zu einer anderen Organisation gehört.

Zusätzlich oder alternativ sollen nur fremde Daten akzeptiert werden, die von verifizierten Organisationen oder Netzwerkknoten stammen. Dies soll durch gängige Sicherheitsverfahren wie Zertifikate gewährleistet werden.

Durch diese Struktur sind die eigenen Daten des jeweiligen Netzwerkknotens vorzugsweise nur in einem Teilbaum der Baumstruktur geschrieben, der durch die Identifikation des jeweiligen Netzwerkknotens gekennzeichnet ist.

Auf diese Weise schreibt jeder Knoten die eigenen Daten nur in seinem eigenen Teilbaum, sodass die Daten auch ohne Quorum oder Locking konsistent sind.

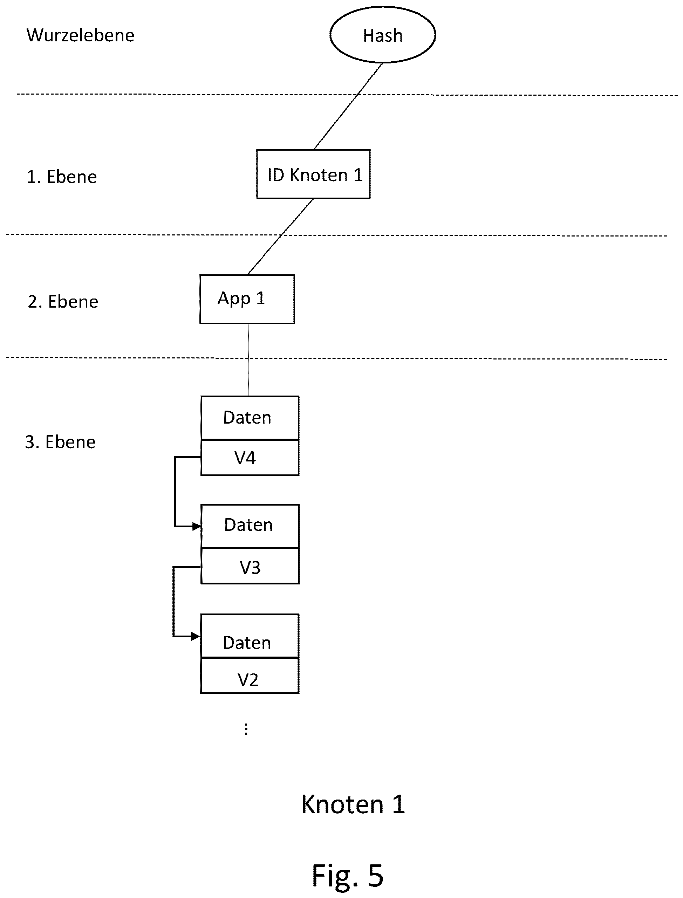

Im Folgenden wird die Baumstruktur anhand Fig. 5, Fig. 6 und Fig. 7 näher betrachtet, die Beispiele einer Datenspeicherung auf Knoten 1 illustrieren.

In Fig. 5 wird ein Anfangszustand von Knoten 1 gezeigt, wobei auf Knoten 1 sich nur seine eigenen Daten befinden. Das heißt, es wurden noch keine Daten von anderen Knoten synchronisiert. Somit befindet sich auf der ersten Ebene nur seine eigene ID, auf der zweiten Ebene nur Informationen über seine eigene(n) Applikation(en), und in der dritten Ebene nur Daten, die durch seine eigene(n) Applikation(en) erzeugt wurden. Der Hash wird auf Basis seiner eigenen Daten erzeugt.

Neuen erzeugten Daten wird vorzugsweise jeweils eine Versionsnummer zugewiesen, durch die neue und alte Daten verknüpft werden können.

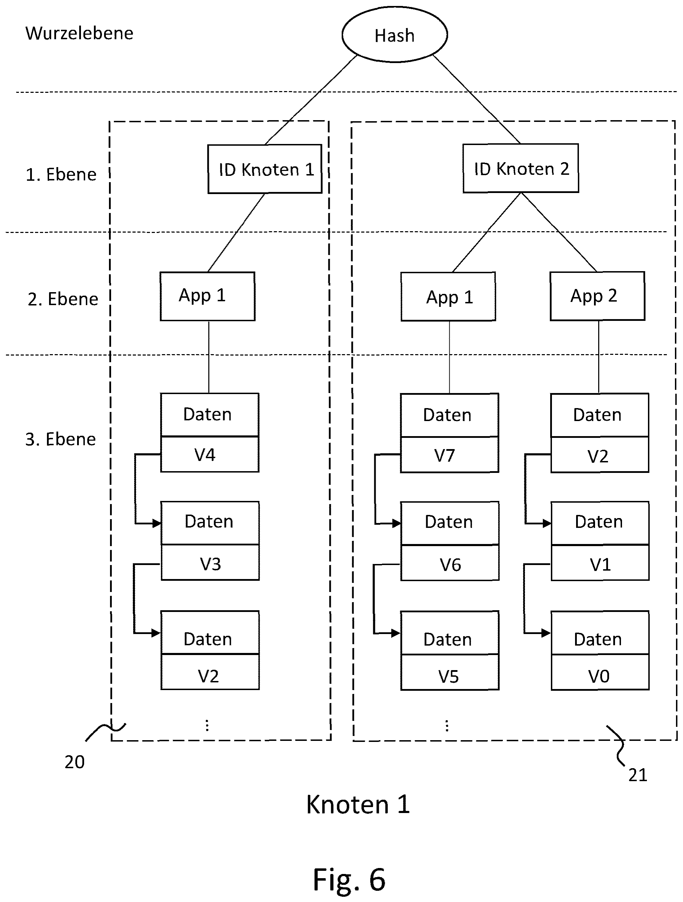

In Fig. 6 wird ein Zustand gezeigt, in dem die Daten von Knoten 2 auf Knoten 1 synchronisiert wurden. In diesem Fall umfasst die erste Ebene der Baumstruktur nicht nur die ID von Knoten 1, sondern auch die ID von Knoten 2. Die zweite Ebene enthält Informationen zu den jeweiligen Anwendungen unter jedem Knoten, und die dritte Ebene enthält die von den Anwendungen erzeugten Nutzdaten. Die gestrichelte Box 20 enthält eigene Daten von Knoten 1, während die gestrichelte Box 21 fremde Daten von anderen Knoten darstellt. Der Hash wird aus den eigenen Daten in Kombination mit den fremden Daten generiert.

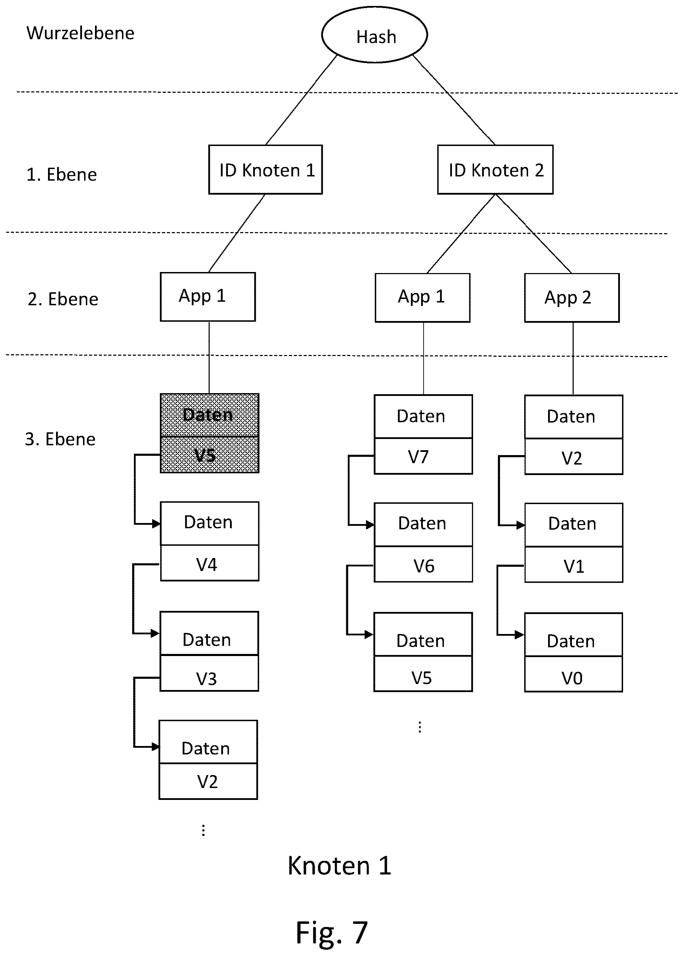

Knoten 1 schreibt neue Daten, die durch ihre eigene(n) Applikation(en) erzeugt wurden, welche in Fig. 7 schattiert dargestellt sind, ausschließlich in ihren eigenen Teilbaum. Analogerweise schreibt Knoten 2 neue entstandenen Daten, die durch seiner eigene(n) Anwendung(en) erzeugt wurden, ebenfalls nur in seinen eigenen Teilbaum. Auf diese Weise sind Daten auch ohne Quorum oder Locking konsistent.

Wie bereits erwähnt, kann sich das Netzwerk in einer DDIL-Umgebung befinden. Daher sind Knoten 1 und Knoten 2 jeweils dafür eingerichtet, opportunistisch zu kommunizierten. Das heißt, die zuvor beschriebenen Schritte S102, S201, S203, S103, S104, S204, S206 und/oder S105 opportunistisch erfolgen kann.

Der Begriff opportunistische Kommunikation beschreibt eine Kommunikation oder Datenübertragung, die basierend auf Gelegenheiten oder verfügbaren Ressourcen erfolgt. Typischerweise können bei opportunistischer Kommunikation alternative Kommunikationswege oder Ressourcen genutzt werden, wenn zum Beispiel die Hauptkommunikationsverbindung möglicherweise nicht verfügbar oder suboptimal ist.

Vorzugsweise erfolgt die Kommunikation zwischen dem ersten Netzwerkknoten und dem zweiten Netzwerkknoten durch IP-basierte Netzwerktechnologie.

IP-basierte Netzwerktechnologie bezieht sich auf Netzwerktechnologie, die das Internet Protocol (IP) verwendet, um Daten zwischen Netzwerkknoten zu übertragen.

Vorzugsweise verwendet die IP-basierte Netzwerktechnologie eine oder mehrere der folgenden Kommunikationswege: IEEE 802.11 , IEEE 802.3, ITU-T G.992/993, ITU-T G.9700/9701, ITU G.984 ITU-T Y.4480, 3G-6G mobile communication (3GPP).

3G-6G mobile communication (3GPP) (3G/LTE/5G) sind Mobilfunktechnologie, die hohe Datenübertragungsraten über Mobilfunknetze ermöglicht, wobei sie in Krisensituationen oft schwer zu gewährleisten sind, da diese Technologien eine robuste Infrastruktur und eine stabile Stromversorgung erfordern, die unter solchen Umständen möglicherweise nicht immer verfügbar sind.

ITU-T G.992/993, G.9700/9701, G.984 (DSL/G.fast) ist eine Breitbandtechnologie, die Datenübertragung über herkömmliche Kupfer-Telefonleitungen ermöglicht. Es umfasst verschiedene Varianten wie ADSL und VDSL, die unterschiedliche Übertragungsraten bieten. DSL ist allerdings ebenfalls schwer zu gewährleisten in DDIL-Umgebungen.

IEEE 802.3 (Ethernet) ist ein Standard für lokale Netzwerke (LANs) und nutzt Twisted-Pair-Kabel wie CAT5e oder CAT6. Es bietet hohe Übertragungsgeschwindigkeiten von typischerweise 10 Mbps bis zu mehreren Gbps.

IEEE 802.11 (WiFi), auch bekannt als WLAN (Wireless Local Area Network), ist eine drahtlose Netzwerktechnologie, die auf den IEEE 802.11 Standards basiert. Sie ermöglicht die drahtlose Kommunikation zwischen Geräten über Funkwellen innerhalb eines begrenzten geographischen Bereichs. WiFi nutzt Frequenzbänder im 2,4-GHz- und 5-GHz-Bereich und bietet hoch Datenübertragungsraten. Ein Nachteil von WiFi ist aber die begrenzte Reichweite.

In dieser Anmeldung wird WiFi als Netzwerktechnologie verstanden, die auf 802.11a, 802.11b, 802.11g, 802.11n, 802,11ac oder 802.11ax basiert, um es von Halow zu unterscheiden.

Halow ist ein spezieller WLAN-Standard, der auf IEEE 802.11ah basiert. Halow wurde speziell für das Internet der Dinge (IoT) entwickelt und bietet eine deutliche größere Reichweite im Vergleich zu traditionellen WiFi-Standards wie 802.11a/b/g/n/ac/ax. Je nach Umgebung kann Halow Entfernungen von mehreren hundert Metern bis zu mehreren Kilometern abdecken. Halow verwendet typischerweise Frequenzen im Sub-1-GHz-Bereich (z.B. 900 MHz), was ihm eine bessere Durchdringung von Hindernissen und eine verbesserte Übertragungsstabilität in DDIL-Umgebungen ermöglicht. Zudem ist der Standard darauf ausgelegt, einen niedrigen Energieverbrauch zu ermöglichen, was auch in DDIL-Umgebungen vorteilhaft ist.

ITU-T Y.4480 LoRa (Long Range) ist eine drahtlose Low-Power Wide-Area Network (LPWAN)-Technologie, die ebenfalls speziell für das loT entwickelt wurde. Zudem arbeitet LoRa auch im Sub-1-GHz-Bereich (z.B. 868 MHz in Europa, 915 MHz in Nordamerika). Im Vergleich zu Halow bietet LoRa aber eine sehr hohe Reichweite von mehreren Kilometern, sogar in städtischen Umgebungen mit vielen Hindernissen. Insbesondere verwendet LoRa Chirp Spread Spectrum (CSS), eine spezielle Modulationstechnik, die hohe Reichweite und Energieeffizienz ermöglicht.

Es ist anzumerken, dass die hier erwähnten Kommunikationswege nur beispielhaft sind. Andere Kommunikationswege können ebenfalls verwendet werden. Die Erfindung ist diesbezüglich nicht beschränkt.

Eine Mehrzahl der Kommunikationswege kann kombiniert werden, um unterschiedliche Daten bestmöglich zu übertragen, ohne einzelne Verbindung zu überlasten. Dadurch ist die Lösung in DDIL-Umgebungen mit geringem Durchsatz und großer Reichweite, wie beispielsweise in militärischen und BOS-Umfeldern, einsetzbar.

Falls mehrere der Kommunikationswege gleichzeitig verfügbar sind, können sie je nach vorbestimmter Priorität ausgewählt werden. Die Priorisierung ermöglicht eine effiziente Kommunikation und Datenübertragung, um die gewünschte Quality of Service (QoS) sicherzustellen. Beispielsweise können die Kommunikationswege die folgenden Prioritäten besitzen: WiFi>Halow>LoRa.

Es ist anzumerken, dass Fig. 2 lediglich beispielhaft zeigt, wie Daten von Knoten 2 auf Knoten 1 synchronisiert werden. Falls Knoten 1 unterschiedliche Daten zu Knoten 2 enthält, kann es notwendig sein, auch Daten von Knoten 1 auf Knoten 2 zu synchronisieren. In diesem Fall würde Knoten 2 die Schritte ausführen, die in Fig. 2 von Knoten 1 ausgeführt werden, während Knoten 1 die Schritte ausführen würde, die in Fig. 2 von Knoten 2 ausgeführt werden.

Es wird ferner darauf hingewiesen, dass jeder Netzwerkknoten in dem Netzwerk vorzugsweise nicht nur dafür eingerichtet ist, die Schritte ausführen, die in Fig. 2 von Knoten 1 ausgeführt werden, sondern auch dafür eingerichtet ist, die Schritte auszuführen, die in Fig. 2 von Knoten 2 ausgeführt werden.

In anderen Worten ist jeder Netzwerkknoten in dem Netzwerk vorzugsweise dafür eingerichtet, nicht nur Daten aus benachbarten Netzwerkknoten zu ziehen, sondern auch die auf ihm gespeicherten Daten auf anderen Netzwercknoten zu übertragen, wodurch eine Synchronisierung der Daten zwischen allen Netzwerkknoten in dem Netzwerk erreicht werden kann.

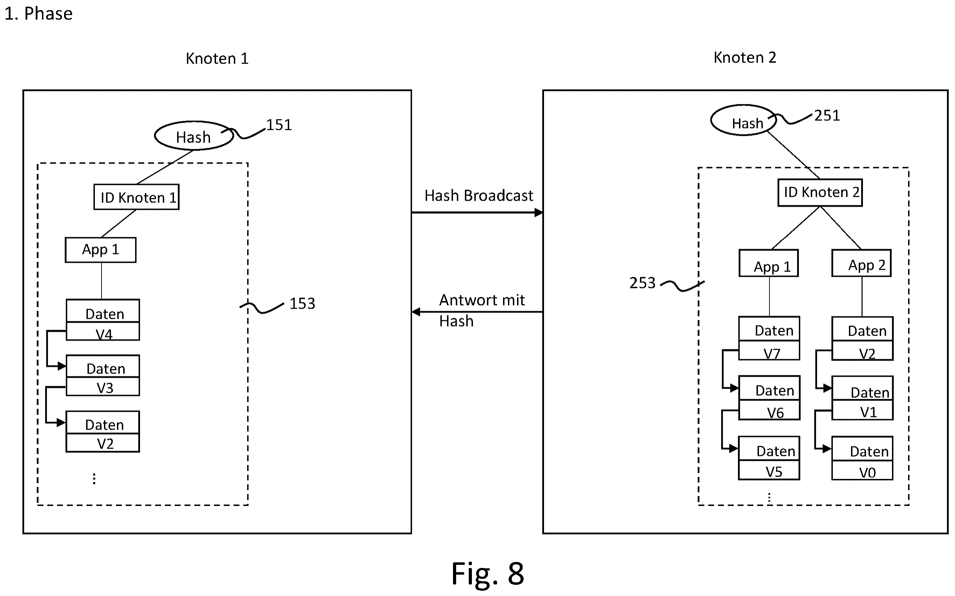

Im Folgenden wird anhand Fig. 8 - Fig. 13 ein Beispiel gezeigt, wie Daten zwischen Knoten 1 und Knoten 2 synchronisiert werden.

Fig. 8 zeigt eine erste Phase des Datensynchronisationsprozesses nach dem Beispiel. Knoten 1 erzeugt einen Hash 151 auf Basis des auf ihm befindlichen Datensatzes 153, und broadcastet den Hash 151 an einen oder andere Knoten, welche den zweiten Knoten 2 umfasst.

Knoten 2 empfängt den Hash 151. Danach erzeugt er einen Hash 251 auf Basis des auf ihm befindlichen Datensatzes 253. Anschließend vergleicht Knoten 2 den Hash 251 mit dem Hash 151, und bestimmt, ob sie gleich sind. Da in dieser Phase der Datensatz 153 auf Knoten 1 und der Datensatz 253 auf Knoten 2 unterschiedlich sind, sind die Hashs 151 und 251 ebenfalls unterschiedlich.

Daraufhin sendet Knoten 2 den Hash 251 an Knoten 1.

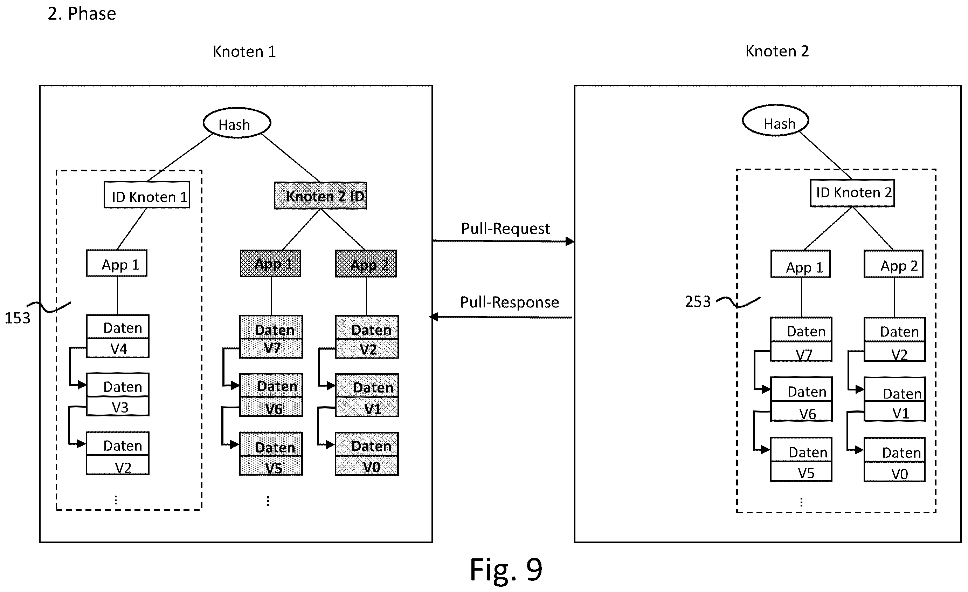

Fig. 9 zeigt eine zweite Phase des Datensynchronisationsprozesses nach dem Beispiel. Nachdem Knoten 1 den Hash 251 empfangen hat, sendet er eine Pull-Request an Knoten 2, wobei die Pull-Request einen Indikator umfasst, der den Datensatz 153 auf Knoten 1 indiziert und die folgende Form haben kann: [ID Knoten 1: App 1: V4]. Es ist anzumerken, dass diese dargestellte Schreibweise des Indikators nur beispielhaft ist und andere Formen annehmen kann. Die Erfindung ist diesbezüglich nicht beschränkt.

Knoten 2 empfängt den Pull-Request von Knoten 1, und bestimmt, auf Basis des Indikators, ob der Datensatz 153 den auf ihm befindlichen Datensatz 253 bereits umfasst. Da es nicht der Fall ist, sendet Knoten 2 eine Pull-Response an Knoten 1, welche einen Datensatz enthält, der dem Datensatz 253 entspricht. Da Knoten 1 und Knoten 2 in der zweiten Phase noch keine gemeinsamen Daten haben, kann eine Kompression des Datensatzes 253 noch nicht unter Verwendung eines Referenzdatensatzes durchgeführt werden. Eine Kompression des Datensatzes 253 kann allerdings mit einem anderen Algorithmus durchgeführt werden, wie zum Beispiel dem Deflate- oder einem LZ-Algorithmus.

Knoten 1 empfängt anschließend die Pull-Response und ggf. dekomprimiert Daten in der Pull-Response, um den Datensatz 253 zu erhalten. Danach speichert Knoten 1 den Datensatz 253 auf sich, wie in Fig. 9 schattiert dargestellt, sodass der Datensatz 253 von Knoten 2 auf Knoten 1 synchronisiert wird.

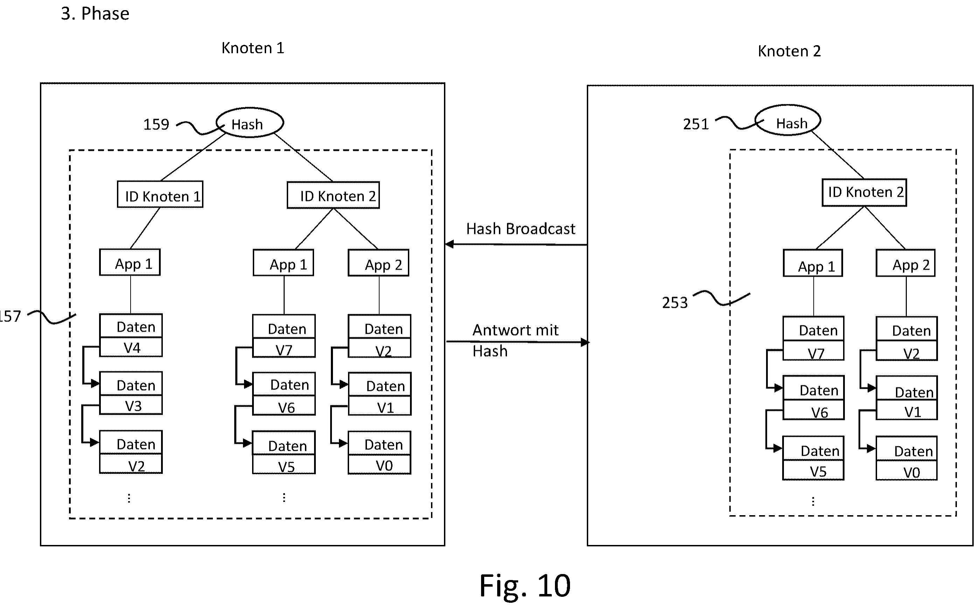

Fig. 10 zeigt eine dritte Phase des Datensynchronisationsprozesses nach dem Beispiel. Knoten 2 broadcastet auch seinen Hash 251, der auf Basis seines Datensatzes 253 erzeugt wird, an einen oder andere Knoten, welche den ersten Knoten 1 umfasst.

Knoten 1 empfängt den Hash 251. Danach erzeugt er einen Hash 159 auf Basis des nun auf ihm befindlichen Datensatzes 157. Anschließend vergleicht Knoten 1 den Hash 159 mit dem Hash 251. Falls der Datensatz 157 auf Knoten 1 und der Datensatz 253 auf Knoten 2 immer noch unterschiedlich sind, sind die Hashs 159 und 251 ebenfalls unterschiedlich. Daraufhin sendet Knoten 1 den Hash 159 an Knoten 2.

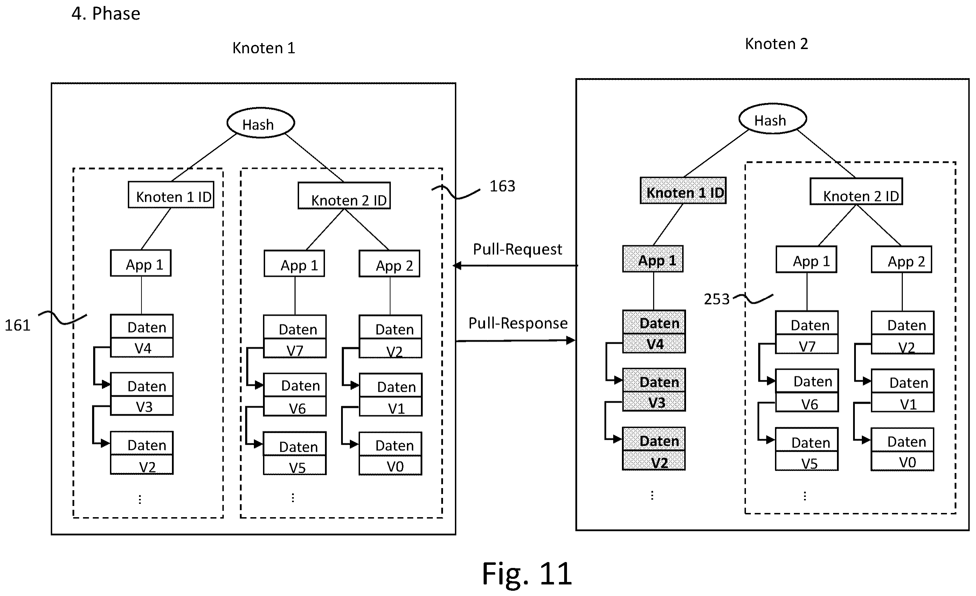

Fig. 11 zeigt eine vierte Phase des Datensynchronisationsprozesses nach dem Beispiel. Nachdem Knoten 2 den Hash 159 empfangen hat, sendet er eine Pull-Request an Knoten 1, wobei die Pull-Request einen Indikator umfasst, der den Datensatz 253 auf Knoten 2 indiziert und die folgende Form haben kann: [ID Knoten 2: App 1: V7:App 2: V2].

Knoten 1 empfängt die Pull-Request von Knoten 2, und bestimmt, auf Basis des Indikators, ob der Datensatz 253 den auf ihm befindlichen Datensatz 157 bereits umfasst. Zudem bestimmt er, auf Basis des Indikators, ob Knoten 1 und Knoten 2 bereits gemeinsame Daten haben.

In diesem Fall umfasst der Datensatz 253 nicht den Datensatz 157. Allerdings ist der Datensatz 253 sowohl auf Knoten 1 als auch auf Knoten 2 gespeichert. Daraufhin sendet Knoten 1 eine Pull-Response an Knoten 2, welche einen Datensatz enthält, der dem Datensatz 161 entspricht, wobei der Datensatz 161 die Differenz zwischen dem Datensatz 157 und dem Datensatz 253 umfasst. Zudem enthält die Pull-Response einen Referenzdatenindikator, der den gemeinsamen Datensatz 253 zwischen Knoten 1 und Knoten 2 indiziert. Der Referenzdatenindikator kann ebenfalls in der folgenden Form sein: [ID Knoten 2: App 1: V7:App 2: V2].

Da Knoten 1 und Knoten 2 in der vierten Phase den gemeinsamen Datensatz 253 besitzen, kann er als ein Referenzdatensatz verwendet werden, um Datensatz 161 zu komprimieren. Die Komprimierung erfolgt vorzugsweise in zwei Stufen. Zunächst wird eine erste Komprimierung unter Verwendung des Referenzdatensatzes durchgeführt, gefolgt von einer zweiten Komprimierung mit dem Deflate- oder Lempel-Ziv-, LZ-, Algorithmus, die die Datenmenge weiter reduzieren kann, wobei der Deflate- oder LZ-Algorithmus den Referenzdatensatz wieder verwenden kann, um ein Preset Dictionary zwischen beiden Knoten zu generieren und/oder aktualisieren.

Knoten 2 empfängt anschließend die Pull-Response und ggf. dekomprimiert Daten in der Pull-Response, um den Datensatz 161 zu erhalten. Die Dekomprimierung kann ebenfalls in zwei Stufen erfolgen. Zunächst wird eine erste Dekomprimierung mit dem Deflate- oder Lempel-Ziv-, LZ-, Algorithmus durchgeführt, gefolgt von einer zweiten Dekomprimierung unter Verwendung des Referenzdatensatzes 253. Anschließend speichert Knoten 2 den Datensatz 161 auf sich, wie in Fig. 11 schattiert dargestellt, sodass der Datensatz 161 von Knoten 1 auf Knoten 2 synchronisiert wird.

Nachdem die vierte Phase abgeschlossen ist, sind Daten zwischen Knoten 1 und Knoten 2 synchronisiert, das heißt, sie sind identisch geworden. Sowohl Knoten 1 als auch Knoten 2 können allerdings jeweils ihren Hash weiterhin regelmäßig broadcasten. Sofern die Hashs gleich sind, findet keine weitere Datenübertragung zwischen Knoten 1 und Knoten 2 statt.

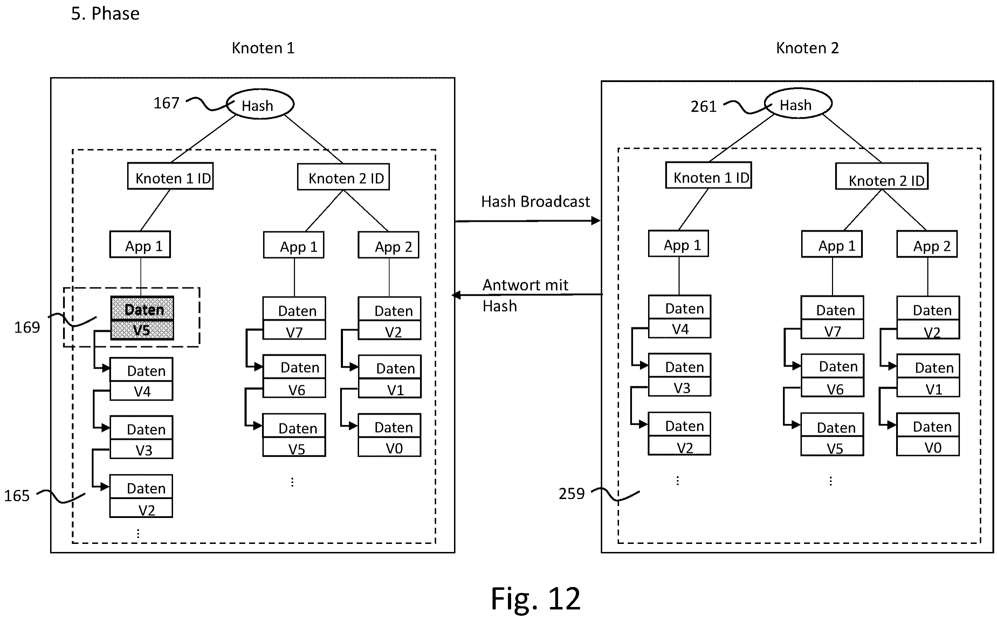

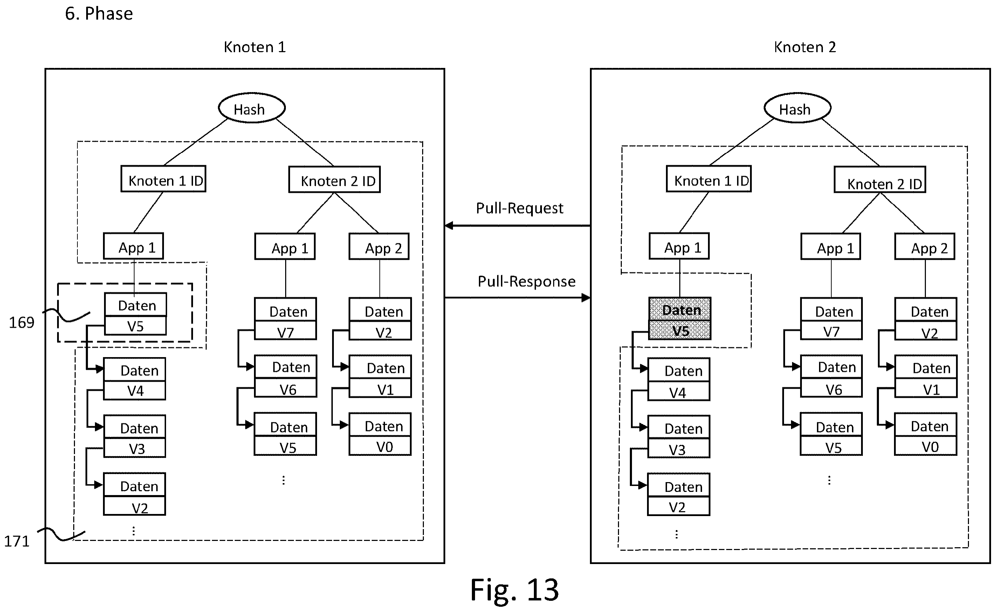

Fig. 12 zeigt eine fünfte Phase des Datensynchronisationsprozesses nach dem Beispiel, in der ein neuer Dateneintrag 169 auf Knoten 1 entstanden ist. Daraufhin sind der Hash 167 und der Hash 261 wieder unterschiedlich, sodass eine Datenübertragung zwischen Knoten 1 und Knoten 2 wieder stattfindet, die in Fig. 13 dargestellt ist.

Knoten 2 sendet eine Pull-Request an Knoten 1, wobei die Pull-Request einen Indikator umfasst, der den Datensatz 259 auf Knoten 2 indiziert und die folgende Form haben kann: [ID Knoten 1: App1:V4:ID Knoten 2: App 1: V7:App 2: V2].

Knoten 1 empfängt die Pull-Request von Knoten 2, und bestimmt, auf Basis des Indikators, ob der Datensatz 259 den auf ihm befindlichen Datensatz 165 bereits umfasst. Zudem bestimmt er, auf Basis des Indikators, ob Knoten 1 und Knoten 2 bereits gemeinsame Daten haben.

In diesem Fall umfasst der Datensatz 259 nicht den Datensatz 165. Allerdings ist der Datensatz 259 sowohl auf Knoten 1 als auch auf Knoten 2 gespeichert.

Daraufhin sendet Knoten 1 eine Pull-Response an Knoten 2, welche einen Datensatz enthält, der dem neuen Dateneintrag 169 entspricht, wobei der neue Dateneintrag 169 die Differenz zwischen dem Datensatz 165 und dem Datensatz 259 umfasst. Zudem kann die Pull-Response einen Referenzdatenindikator enthalten, der den gemeinsamen Datensatz 259 zwischen Knoten 1 und Knoten 2 indiziert. Der Referenzdatenindikator kann ebenfalls in der folgenden Form sein: [ID Knoten 1: App1:V4:ID Knoten 2: App 1: V7:App 2:V2].

Der Datensatz 259 kann als ein Referenzdatensatz verwendet werden, um den Datensatz 169 zu komprimieren, wobei die Komprimierung wie zuvor diskutiert ebenfalls in zwei Stufen erfolgen kann. Falls eine Komprimierung stattfindet, enthält die Pull-Response vorzugsweise ferner einen Komprimierungsindikator, welche die verwendete Komprimierung, das heißt die erste Komprimierung und/oder die zweite Komprimierung, indiziert.

Knoten 2 empfängt anschließend die Pull-Response und ggf. dekomprimiert den Datensatz in der Pull-Response, um den Datensatz 169 zu erhalten. Danach speichert Knoten 2 den Datensatz 169 auf sich, wie in Fig. 13 schattiert dargestellt, sodass der Datensatz 169 von Knoten 1 auf Knoten 2 synchronisiert wird.

Es ist anzumerken, dass die erste Phase, die dritte Phase und/oder die fünfte Phase optional sind. Das heißt, dass das Verfahren auch ohne einen Austausch der Hash-Werte zwischen Knoten durchgeführt werden kann.

Die Sicherheit des Synchronisierungsverfahrens kann durch Standardverfahren gewährleistet werden. Die Kommunikation zwischen verschiedenen Knoten kann durch TLS verschlüsselt werden. Die Persistenz der Daten kann in verschlüsselten Dateien erfolgen. Zudem können Berechtigungsmanagement und eine PKI verwendet werden, um Applikationen zu authentifizieren und die Synchronisation mit vertrauenswürdigen Knoten zu ermöglichen. Dabei erfolgt eine Unterscheidung zwischen vertrauenswürdigen und eigenen Zertifikaten.

Das beschriebene Synchronisationsverfahren kann durch ein Computerprogramprodukt, auch als Synchronisationssoftware bezeichnet, realisiert werden, wobei die Synchronisationssoftware auf jedem Knoten im Netzwerk installiert ist.

Das Anwendungsgebiet der Synchronisationssoftware deckt ein breites Spektrum ab, einschließlich militärischer Anwendungen, Katastrophenschutz, Behördenkommunikation, Führungssysteme sowie effiziente Datenverteilung in unterschiedlichen Netzwerkdiensten.

Wie bereits diskutiert, eignet sich die beschriebene Technologie besonders für den Einsatz in DDIL-Umgebungen. Dies umfasst Bereiche, in denen herkömmliche Infrastruktur möglicherweise nicht vorhanden oder ausgefallen ist, wie Katastropheneinsätze und militärischen Operationen.

Ein weiteres Anwendungsgebiet der Synchronisationssoftware liegt im effizienten Verteilen von Daten für verschiedene Netzwerkdienste. Dies umfasst das Propagieren von DNS-Einträgen, Routinginformationen oder Service Discovery sowie das Verteilen von Zertifikaten und Revocation-Lists.

Aufbauend darauf ermöglicht die Synchronisationssoftware das Bootstraping von Netzwerken, also den Aufbau eines Netzwerks ohne vorherige Konfiguration. Dies ist besonders nützlich in Umgebungen, in denen keine vorab festgelegte Infrastruktur vorhanden ist, wie in Mobile Ad-hoc Networks (MANET).

## Patentansprüche

1. Verfahren, durchgeführt durch einen ersten Netzwerkknoten oder ein Chipsystem für den ersten Netzwerkknoten, umfassend:
Senden (S104) einer Anfrage an einen zweiten Netzwerkknoten, wobei die Anfrage einen Indikator umfasst, der einen ersten Datensatz (10) auf dem ersten Netzwerkknoten indiziert;
Empfangen (S105) einer Antwort von dem zweiten Netzwerkknoten, wobei die Antwort einen dritten Datensatz umfasst, der einem vierten Datensatz (16) auf dem zweiten Netzwerkknoten entspricht, wobei der vierte Datensatz (16) eine Differenz zwischen einem zweiten Datensatz (12) auf dem zweiten Netzwerkknoten und dem ersten Datensatz (10) umfasst, wobei der zweite Datensatz (12) den vierten Datensatz (16) umfasst; und
Speichern (S106) des vierten Datensatzes auf dem ersten Netzwerkknoten auf Basis der Antwort.

2. Verfahren nach Anspruch 1, wobei das Verfahren, vor dem Senden der Anfrage an den zweiten Netzwerkknoten, ferner umfasst:
Erzeugen (S101) eines ersten Hashs auf Basis des ersten Datensatzes (10) auf dem ersten Netzwerkknoten;
Broadcasting (S102) des ersten Hashs an einen oder mehrere Netzwerkknoten, welche den zweiten Netzwerkknoten umfassen; und/oder
Empfangen (S103) eines zweiten Hashs von dem zweiten Netzwerkknoten, wobei der zweite Hash auf Basis des zweiten Datensatzes (12) auf dem zweiten Netzwerkknoten erzeugt ist.

3. Verfahren nach Anspruch 1 oder Anspruch 2, wobei der dritte Datensatz aus einer Komprimierung des vierten Datensatzes (16) entstanden ist.

4. Verfahren nach Anspruch 3, wobei die Antwort ferner einen Komprimierungsindikator und einen Referenzdatenindikator umfasst, wobei der Komprimierungsindikator die Komprimierung indiziert, und der Referenzdatenindikator einen Referenzdatensatz (14) indiziert, wobei der Referenzdatensatz (14) gemeinsame Daten zwischen dem ersten Datensatz (10) und dem zweiten Datensatz (12) umfasst.

5. Verfahren nach einem der Ansprüche 1-4, wobei das Speichern (S106) des vierten (16) Datensatzes auf dem ersten Netzwerkknoten auf Basis der Antwort umfasst:
Dekomprimieren des dritten Datensatzes, um den vierten Datensatz (16) zu erhalten; und Speichern des vierten Datensatzes (16) auf dem ersten Netzwerkknoten.

6. Verfahren nach Anspruch 5, wobei eine Dekomprimierung des dritten Datensatzes eine erste Dekomprimierung und/oder eine zweite Dekomprimierung umfasst.

7. Verfahren nach Anspruch 6, wobei die erste Dekomprimierung den Deflate- oder einen Lempel-Ziv-, LZ, Algorithmus verwendet.

8. Verfahren nach Anspruch 6 oder Anspruch 7, wobei die zweite Dekomprimierung unter Verwendung eines Referenzdatensatzes (14) durchgeführt wird, wobei der Referenzdatensatz (14) gemeinsame Daten zwischen dem ersten Datensatz (10) und dem zweiten Datensatz (12) umfasst.

9. Verfahren, durchgeführt durch einen zweiten Netzwerkknoten oder ein Chipsystem für den zweiten Netzwerkknoten, umfassend:
Empfangen (S204) einer Anfrage von einem ersten Netzwerkknoten, wobei die Anfrage einen Indikator umfasst, der einen ersten Datensatz (10) auf dem ersten Netzwerkknoten indiziert;
Bestimmen (S205), auf Basis des Indikators, ob der erste Datensatz (10) einen zweiten Datensatz (12) auf dem zweiten Netzwerkknoten umfasst;
wenn der erste Datensatz (10) den zweiten Datensatz (12) auf dem zweiten Netzwerkknoten nicht umfasst, umfasst das Verfahren ferner:
Senden (S206) einer Antwort an den ersten Netzwerkknoten, wobei die Antwort einen dritten Datensatz umfasst, der einem vierten Datensatz (16) auf dem zweiten Netzwerkknoten entspricht, wobei der vierte Datensatz (16) eine Differenz zwischen dem zweiten Datensatz und dem ersten Datensatz umfasst, wobei der zweite Datensatz (12) den vierten Datensatz (16) umfasst.

10. Verfahren nach Anspruch 9, wobei das Verfahren, vor dem Empfangen einer Anfrage von einem ersten Netzwerkknoten, ferner umfasst:
Empfangen (S201) eines ersten Hashs von dem ersten Netzwerkknoten, wobei der erste Hash auf Basis des ersten Datensatzes (10) auf dem ersten Netzwerkknoten erzeugt ist;
Erzeugen (S202) eines zweiten Hashs auf Basis des zweiten Datensatzes (12) auf dem zweiten Netzwerkknoten;
Senden (S203) des zweiten Hashs an den ersten Netzwerkknoten falls der erste Hash und der zweite Hash unterschiedlich sind, und/oder Broadcasten des zweiten Hashs.

11. Verfahren nach Anspruch 9 oder Anspruch 10, wobei der dritte Datensatz durch eine Komprimierung des vierten Datensatzes (16) erzeugt wird.

12. Verfahren nach Anspruch 11, wobei die Komprimierung eine erste Komprimierung und/oder eine zweite Komprimierung umfasst.

13. Verfahren nach Anspruch 12, wobei die erste Komprimierung unter Verwendung eines Referenzdatensatzes durchgeführt wird, wobei der Referenzdatensatz (14) gemeinsame Daten zwischen dem ersten Datensatz (10) und dem zweiten Datensatz (12) umfasst.

14. Verfahren nach Anspruch 12 oder Anspruch 13, wobei die zweite Komprimierung den Deflate- oder einen Lempel-Ziv-, LZ-, Algorithmus verwendet, welcher vorzugsweise den Referenzdatensatz (14) verwendet, um ein Preset-Dictionary zu erstellen und/oder zu trainieren.

15. Verfahren nach einem der Ansprüche 11-14, wobei die Antwort ferner einen Komprimierungsindikator und einen Referenzdatenindikator umfasst, wobei der Komprimierungsindikator die Komprimierung indiziert, und der Referenzdatenindikator den Referenzdatensatz (14) indiziert.

16. Verfahren nach einem der Ansprüche 12-15, wobei die erste Komprimierung oder die zweite Komprimierung nur durchgeführt wird, bzw. Ergebnisse der ersten Komprimierung oder der zweiten Komprimierung nur übernommen werden, wenn festgestellt wird, dass die jeweilige Komprimierung Erfolg hat.

17. Verfahren nach Anspruch 16, wobei das Verfahren ferner umfasst:
Feststellen des Erfolgs der jeweiligen Komprimierung anhand eines Vergleichs zwischen der Zeit, die für die jeweilige Komprimierung benötigt wird, und einer geschätzten Übertragungszeit für unkomprimierte Daten,
und/oder
Feststellen des Erfolgs der jeweiligen Komprimierung anhand eines Vergleichs zwischen der Datengröße vor und nach der jeweiligen Komprimierung.

18. Verfahren nach einem der Ansprüche 1-17, wobei der erste Netzwerkknoten und der zweite Netzwerkknoten dafür eingerichtet sind, miteinander opportunistisch zu kommunizieren.

19. Verfahren nach einem der Ansprüche 1-18, wobei die Kommunikation zwischen dem ersten Netzwerknoten und dem zweiten Netzwerkknoten durch IP-basierte Netzwerktechnologie über beliebige Mobilfunk- Satteliten- oder Weitverkehrsnetze erfolgt, welche eine oder mehrere Kommunikationswege verwendet, die beispielsweise mindestens eine der folgenden umfassen: IEEE 802.11 , IEEE 802.3, ITU-T G.992/993, ITU-T G.9700/9701, ITU G.984 ITU-T Y.4480, 3G-6G mobile communication (3GPP).

20. Verfahren nach Anspruch 19, wobei, falls mehrere der Kommunikationswege gleichzeitig verfügbar sind, diese je nach vorbestimmter Priorität oder aufgrund von Netzwerkmetriken ausgewählt werden.

21. Verfahren nach einem der Ansprüche 1-20, wobei der erste Datensatz und der zweite Datensatz jeweils in einer Baumstruktur gespeichert sind, wobei die Baumstruktur vier Ebenen umfasst: eine Wurzelebene, die den jeweilige Hash repräsentiert, der auf Basis des jeweiligen Datensatzes durch eine Hashfunktion generiert ist; eine erste Ebene, in der Identifikationen einer oder mehrerer Netzwerkknoten abgelegt sind, welche zumindest die Identifikation des Netzwerkknotens umfassen, auf dem sich der jeweilige Datensatz befindet; eine zweite Ebene, in der Informationen über eine oder mehrere Applikationen, die den einen oder mehreren Netzwerkknoten untergeordnet sind, abgelegt sind; eine dritte Ebene, in der Dateninstanzen abgelegt sind, die den einen oder mehreren Applikationen untergeordnet sind, wobei der jeweilige Datensatz Daten der ersten Ebene, der zweiten Ebene und der dritten Ebene der Baumstruktur umfasst.

22. Verfahren nach einem der Ansprüche 1-21, wobei der erste Datensatz und der zweite Datensatz jeweils eigene Daten (20) des jeweiligen Netzwerkknotens und fremde Daten (21) zumindest eines anderen Netzwerkknotens umfassen.

23. Verfahren nach Anspruch 22, wobei die eigenen Daten des jeweiligen Netzwerkknotens sowie fremde Daten von einem Netzwerkknoten innerhalb derselben Organisation wie der jeweilige Netzwerkknoten eine höhere Priorität bei der Übertragung durch den jeweiligen Netzwerkknoten haben als fremde Daten von einem Netzwerkknoten, der zu einer anderen Organisation gehört.

24. Verfahren nach Anspruch 22 oder Anspruch 23, wobei die eigenen Daten des jeweiligen Netzwerkknotens nur in einem Teilbaum der Baumstruktur geschrieben sind, der durch die Identifikation des jeweiligen Netzwerkknotens gekennzeichnet ist.

25. Verfahren, umfassend:
Senden (S104) einer Anfrage an einen zweiten Netzwerkknoten durch einen ersten Netzwerkknoten, wobei die Anfrage einen Indikator umfasst, der einen ersten Datensatz (10) auf dem ersten Netzwerkknoten indiziert;
Empfangen (S204) der Anfrage von dem ersten Netzwerkknoten durch einen zweiten Netzwerkknoten;
Bestimmen (S205), durch den zweiten Netzwerkknoten auf Basis des Indikators, ob der erste Datensatz (10) einen zweiten Datensatz (12) auf dem zweiten Netzwerkknoten umfasst;
wenn der erste Datensatz (10) den zweiten Datensatz (12) nicht umfasst, umfasst das Verfahren ferner:
Senden (S206) einer Antwort an den ersten Netzwerkknoten durch den zweiten Netzwerkknoten, wobei die Antwort einen dritten Datensatz umfasst, der einem vierten Datensatz (16) auf dem zweiten Netzwerkknoten entspricht, wobei der vierte Datensatz (16) eine Differenz zwischen dem zweiten Datensatz (12) und dem ersten Datensatz (10) umfasst, wobei der zweite Datensatz (12) den vierten Datensatz (16) umfasst;
Empfangen (S105) der Antwort von dem zweiten Netzwerkknoten durch den ersten Netzwerkknoten; und
Speichern (S106) des vierten Datensatzes (16) auf dem ersten Netzwerkknoten durch den ersten Netzwerkknoten basierend auf der Antwort.

26. Verfahren nach Anspruch 25, wobei das Verfahren, vor dem Senden der Anfrage an den zweiten Netzwerkknoten durch den ersten Netzwerkknoten, ferner umfasst:
Erzeugen (S101) eines ersten Hashs auf Basis des ersten Datensatzes (10) auf dem ersten Netzwerkknoten durch den ersten Netzwerkknoten;
Broadcasting (S102) des ersten Hashs an einen oder mehrere Netzwerkknoten durch den ersten Knoten, welche den zweiten Netzwerkknoten umfassen;
Empfangen (S201) des ersten Hashs von dem ersten Netzwerkknoten durch den zweiten Netzwerkknoten;
Erzeugen (S202) eines zweiten Hashs auf Basis des zweiten Datensatzes (12) auf dem zweiten Netzwerkknoten durch den zweiten Netzwerkknoten;
Senden (S203) des zweiten Hashs an den ersten Netzwerkknoten durch den zweiten Netzwerkknoten, falls der erste Hash und der zweite Hash unterschiedlich sind; und
Empfangen (S103) eines zweiten Hashs von dem zweiten Netzwerkknoten durch den ersten Netzwerkknoten.

27. Ein Netzwerk, umfassend einen ersten Netzwerkknoten und einen zweiten Netzwerkknoten, wobei der erste Netzwerkknoten dafür eingerichtet ist, das Verfahren nach einem der Ansprüche 1-8 oder 18-24 durchzuführen, und der zweite Netzwerkknoten dafür eingerichtet ist, das Verfahren nach einem der Ansprüche 9-24 durchzuführen.

28. Ein Netzwerkknoten, welcher dafür eingerichtet ist, das Verfahren nach einem der Ansprüche 1-24 durchzuführen.

29. Ein Netzwerk, umfassend eine Mehrzahl von Netzwerkknoten, wobei jeder der Mehrzahl von Netzwerkknoten dafür eingerichtet ist, das Verfahren nach einem der Ansprüche 1-24 durchzuführen.

30. Computerlesbares Medium, umfassend Befehle, die bei der Ausführung durch einen Computer diesen veranlassen, das Verfahren nach einem der Ansprüche 1-24 durchzuführen.

31. Computerprogrammprodukt, umfassend Befehle, die bei der Ausführung des Programms durch einen Computer diesen veranlassen, das Verfahren nach einem der Ansprüche 1-24 durchzuführen.
